# EUROPEAN PATENT APPLICATION

(11) **EP 4 557 371 A1**
(43) Date of publication of application: **21.05.2025**
(21) Application number: 23839384.7
(22) Date of filing: 12.06.2023
(51) Int. Cl.: H01L 27/146

(54) **IMAGING DEVICE**

(30) Priority: 12.07.2022 US 202263388556 P
(71) Applicant: Sony Semiconductor Solutions Corporation, Atsugi-shi, Kanagawa 243-0014 (JP)
(72) Inventor: KIKUCHI, Yoshiaki, Atsugi-shi, Kanagawa 243-0014 (JP); OUCHI, Hidemitsu, Atsugi-shi, Kanagawa 243-0014 (JP); TOMITA, Manabu, Atsugi-shi, Kanagawa 243-0014 (JP); HAYASHI, Toshiki, Atsugi-shi, Kanagawa 243-0014 (JP); CHIBA, Hisashi, Atsugi-shi, Kanagawa 243-0014 (JP); KUMANO, Hideomi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/021813
(87) International publication number: WO 2024/014209

(57) **Abstract**

An imaging device according to one embodiment of the present disclosure includes a photoelectric converter, a first active element, and a first semiconductor layer. The photoelectric converter generates electric charge corresponding to a light reception amount. The first active element performs a predetermined operation on the electric charge generated by the photoelectric converter, and includes a gate electrode including a first electrode part, a second electrode part, and a third electrode part. The first electrode part and the second electrode part are provided side by side in a first direction. The third electrode part couples the first electrode part and the second electrode part to each other. The first semiconductor layer includes a first surface and a second surface opposed to each other, has the first electrode part and the second electrode part of the gate electrode embedded in the first semiconductor layer on side of the first surface, and includes a first semiconductor region between the first electrode part and the second electrode part. The first semiconductor region is non-doped.

## Description

### Technical Field

The present disclosure relates to an imaging device, for example.

### Background Art

For example, PTL 1 discloses a solid-state imaging device in which an amplification transistor is formed on one surface of a semiconductor substrate. The amplification transistor includes a gate electrode including a vertical gate electrode part embedded from the one surface in a depth direction. The semiconductor substrate includes a p-type layer that is a well layer.

### Citation List

### Patent Literature

PTL 1: Japanese Unexamined Patent Application Publication No. 2021-34435

### Summary of the Invention

Incidentally, in an imaging device having a three-dimensional structure as described above, it is required to reduce generation of a dark current.

It is desirable to provide an imaging device that makes it possible to improve a device characteristic.

An imaging device according to one embodiment of the present disclosure includes a photoelectric converter, a first active element, and a first semiconductor layer. The photoelectric converter generates electric charge corresponding to a light reception amount. The first active element performs a predetermined operation on the electric charge generated by the photoelectric converter, and includes a gate electrode including a first electrode part, a second electrode part, and a third electrode part. The first electrode part and the second electrode part are provided side by side in a first direction. The third electrode part couples the first electrode part and the second electrode part to each other. The first semiconductor layer includes a first surface and a second surface opposed to each other, has the first electrode part and the second electrode part of the gate electrode embedded in the first semiconductor layer on side of the first surface, and includes a first semiconductor region between the first electrode part and the second electrode part. The first semiconductor region is non-doped.

In the imaging device according to one embodiment of the present disclosure, in the first semiconductor layer in which the first electrode part and the second electrode part included in the gate electrode of the first active element are embedded, the non-doped first semiconductor region is formed between the first electrode part and the second electrode part. This allows the entire first semiconductor layer between the first electrode part and the second electrode part to be used as a channel region.

### Brief Description of Drawings

[FIG. 1] FIG. 1 is a block diagram illustrating an example of a functional configuration of an imaging device according to an embodiment of the present disclosure.
[FIG. 2] FIG. 2 is a schematic plan diagram illustrating a schematic configuration of the imaging device illustrated in FIG. 1.
[FIG. 3] FIG. 3 is a schematic diagram illustrating a cross-sectional configuration along a line A-A' illustrated in FIG. 2.
[FIG. 4] FIG. 4 is an equivalent circuit diagram of a unit cell illustrated in FIG. 1.
[FIG. 5] FIG. 5 is a schematic diagram illustrating an example of a cross-sectional configuration of the imaging device illustrated in FIG. 1.
[FIG. 6A] FIG. 6A is a schematic diagram illustrating an example of a plan layout of a first substrate illustrated in FIG. 5.
[FIG. 6B] FIG. 6B is a schematic diagram illustrating an example of a plan layout of a second substrate illustrated in FIG. 5.
[FIG. 7A] FIG. 7A is a schematic cross-sectional diagram along a line I-I' illustrated in FIG. 6B.
[FIG. 7B] FIG. 7B is a schematic cross-sectional diagram along a line II-II' illustrated in FIG. 6B.
[FIG. 7C] FIG. 7C is a schematic cross-sectional diagram along a line III-III' illustrated in FIG. 6B.
[FIG. 7D] FIG. 7D is a schematic cross-sectional diagram along a line IV-IV' illustrated in FIG. 6B.
[FIG. 8] FIG. 8 is a schematic diagram for describing channels formed in a cutout part.
[FIG. 9] FIG. 9 is an exploded view of the channels formed in the cutout part.
[FIG. 10A] FIG. 10A is a schematic cross-sectional diagram illustrating an example of a manufacturing process of a pixel transistor illustrated in FIG. 7A, etc.
[FIG. 10B] FIG. 10B is a schematic cross-sectional diagram illustrating a process following FIG. 10A.
[FIG. 10C] FIG. 10C is a schematic cross-sectional diagram illustrating a process following FIG. 10B.
[FIG. 10D] FIG. 10D is a schematic cross-sectional diagram illustrating a process following FIG. 10C.
[FIG. 10E] FIG. 10E is a schematic cross-sectional diagram illustrating a process following FIG. 10D.
[FIG. 10F] FIG. 10F is a schematic cross-sectional diagram illustrating a process following FIG. 10E.
[FIG. 10G] FIG. 10G is a schematic cross-sectional diagram illustrating a process following FIG. 10F.
[FIG. 10H] FIG. 10H is a schematic cross-sectional diagram illustrating a process following FIG. 10G.
[FIG. 10I] FIG. 10I is a schematic cross-sectional diagram illustrating a process following FIG. 10H.
[FIG. 10J] FIG. 10J is a schematic cross-sectional diagram illustrating a process following FIG. 10I.
[FIG. 11] FIG. 11 is a schematic cross-sectional diagram for describing another configuration of the pixel transistor of the present disclosure.
[FIG. 12] FIG. 12 is a schematic cross-sectional diagram for describing a manufacturing process of the pixel transistor illustrated in FIG. 11.
[FIG. 13] FIG. 13 is a schematic cross-sectional diagram for describing another example of the manufacturing process of the pixel transistor illustrated in FIG. 7A, etc.
[FIG. 14] FIG. 14 is a schematic diagram for describing a path of an input signal to the imaging device illustrated in FIG. 3.
[FIG. 15] FIG. 15 is a schematic diagram for describing a signal path of a pixel signal of the imaging device illustrated in FIG. 3.
[FIG. 16] FIG. 16 is a schematic plan diagram illustrating a configuration of a pixel transistor as Comparative example 1.
[FIG. 17] FIG. 17 is a schematic cross-sectional diagram along a line of V-V' illustrated in FIG. 16.
[FIG. 18] FIG. 18 is a schematic cross-sectional diagram along a line of VI-VI' illustrated in FIG. 16.
[FIG. 19] FIG. 19 is a schematic diagram illustrating an example of a plan layout of a fin.
[FIG. 20] FIG. 20 is a schematic cross-sectional diagram illustrating an example of a shape of the fin formed by etching.
[FIG. 21] FIG. 21 is a schematic cross-sectional diagram illustrating another example of the shape of the fin formed by etching.
[FIG. 22] FIG. 22 is a schematic plan diagram illustrating a configuration of a pixel transistor as Comparative example 2.
[FIG. 23] FIG. 23 is a schematic cross-sectional diagram along a line VIII-VIII' illustrated in FIG. 22.
[FIG. 24] FIG. 24 is a schematic cross-sectional diagram along a line IX-IX' illustrated in FIG. 22.
[FIG. 25] FIG. 25 is a characteristic diagram illustrating respective transconductances (gm) of Comparative example 2 and Example.
[FIG. 26] FIG. 26 is a characteristic diagram illustrating respective current-voltage characteristics of Comparative example 2 and Example.
[FIG. 27] FIG. 27 is a schematic cross-sectional view of a pixel transistor according to Modification example 1 of the present disclosure.
[FIG. 28] FIG. 28 is a characteristic diagram illustrating a relationship between a noise current (Isub) and a lifetime based on a sidewall width.
[FIG. 29A] FIG. 29A is a schematic cross-sectional diagram describing a manufacturing process of a pixel transistor according to Modification example 2 of the present disclosure.
[FIG. 29B] FIG. 29B is a schematic cross-sectional diagram illustrating a process following FIG. 29A.
[FIG. 29C] FIG. 29C is a schematic cross-sectional diagram illustrating a process following FIG. 29B.
[FIG. 29D] FIG. 29D is a schematic cross-sectional diagram illustrating a process following FIG. 29C.
[FIG. 29E] FIG. 29E is a schematic cross-sectional diagram illustrating a process following FIG. 29D.
[FIG. 29F] FIG. 29F is a schematic cross-sectional diagram illustrating a process following FIG. 29E.
[FIG. 29G] FIG. 29G is a schematic cross-sectional diagram illustrating a process following FIG. 29F.
[FIG. 29H] FIG. 29H is a schematic cross-sectional diagram illustrating a process following FIG. 29G.
[FIG. 29I] FIG. 29I is a schematic cross-sectional diagram illustrating a process following FIG. 29H.
[FIG. 29J] FIG. 29J is a schematic cross-sectional diagram illustrating a process following FIG. 29I.
[FIG. 29K] FIG. 29K is a schematic cross-sectional diagram illustrating a process following FIG. 29J.
[FIG. 30] FIG. 30 is a schematic plan diagram illustrating a configuration of the pixel transistor according to Modification example 2 of the present disclosure.
[FIG. 31] FIG. 31 is a block diagram illustrating a configuration example of an electronic apparatus including the imaging device illustrated in FIG. 1.
[FIG. 32A] FIG. 32A is a schematic diagram illustrating an example of an overall configuration of a photodetection system in which the imaging device illustrated in FIG. 1, etc. is used.
[FIG. 32B] FIG. 32B is a diagram illustrating an example of a circuit configuration of the photodetection system illustrated in FIG 32A.
[FIG. 33] FIG. 33 is a block diagram depicting an example of schematic configuration of a vehicle control system.
[FIG. 34] FIG. 34 is a diagram of assistance in explaining an example of installation positions of an outside-vehicle information detecting section and an imaging section.
[FIG. 35] FIG. 35 is a view depicting an example of a schematic configuration of an endoscopic surgery system.
[FIG. 36] FIG. 36 is a block diagram depicting an example of a functional configuration of a camera head and a camera control unit (CCU).

### Modes for Carrying Out the Invention

The following describes an embodiment of the present disclosure in detail with reference to the drawings. The following description is one specific example of the present disclosure, and the present disclosure is not limited to the embodiment described below. In addition, the present disclosure is not limited to positions, dimensions, dimension ratios, and the like of respective components illustrated in the respective diagrams. It is to be noted that the description is given in the following order.
1. Embodiment (an example of an imaging device including a pixel transistor including a non-doped semiconductor region to a bottom of a fin)
2. Modification Examples
   2-1. Modification Example 1 (another example of a configuration of the pixel transistor)
   2-2. Modification Example 2 (another example of a manufacturing method of the pixel transistor)
3. Application Examples
4. Practical Application Examples

### [1. Embodiment]

### [Functional Configuration of Imaging Device]

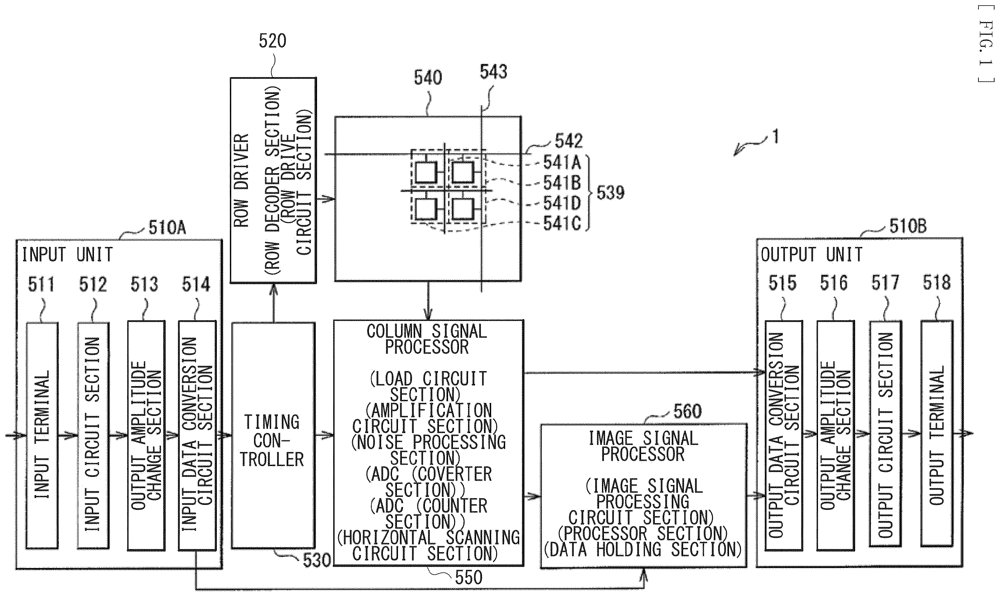

FIG. 1 is a block diagram illustrating an example of a functional configuration of an imaging device (an imaging device 1) according to an embodiment of the present disclosure.

The imaging device 1 in FIG. 1 includes, for example, an input unit 510A, a row driver 520, a timing controller 530, a pixel array unit 540, a column signal processor 550, an image signal processor 560, and an output unit 510B.

In the pixel array unit 540, pixels 541 are repeatedly disposed in an array. More specifically, a unit cell 539 including a plurality of pixels serves as a repeating unit. The unit cells 539 are repeatedly disposed in an array having a row direction and a column direction. It is to be noted that herein, the row direction is sometimes referred to as an H direction and the column direction orthogonal to the row direction is sometimes referred to as a V direction for convenience. In the example of FIG. 1, one unit cell 539 includes, for example, four pixels (pixels 541A, 541B, 541C, and 541D).

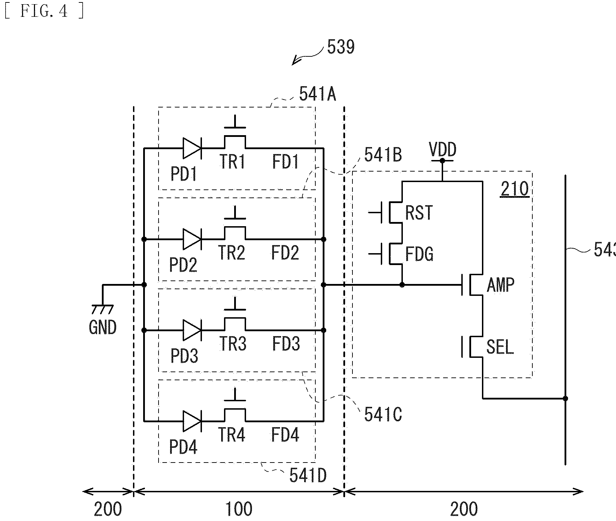

The pixel array unit 540 is provided with a plurality of row drive signal lines 542 and a plurality of vertical signal lines (column readout lines) 543, together with the pixels 541A, 541B, 541C, and 541D. Each of the row drive signal lines 542 drives the pixels 541 included in each of the plurality of unit cells 539 arranged side by side in the row direction in the pixel array unit 540. The respective pixels arranged side by side in the row direction in the unit cell 539 are driven. As will be described in detail below with reference to FIG. 4, the unit cell 539 is provided with a plurality of transistors. To drive the plurality of respective transistors, the plurality of row drive signal lines 542 is coupled to one unit cell 539. The unit cell 539 is coupled to the vertical signal line (column readout line) 543. A pixel signal is read out from each of the pixels 541A, 541B, 541C, and 541D included in the unit cell 539 via the vertical signal line (column readout line) 543.

The row driver 520 includes, for example, a row address control section or a row decoder section, and a row drive circuit section. The row address control section determines a position of a row in which pixels are driven. The row drive circuit section generates signals for driving the pixels 541A, 541B, 541C, and 541D.

The column signal processor 550 is coupled to, for example, the vertical signal line 543. The column signal processor 550 includes a load circuit section that forms a source follower circuit together with the pixels 541A, 541B, 541C, and 541D (the unit cell 539). The column signal processor 550 may include an amplification circuit section that amplifies a signal read out from the unit cell 539 via the vertical signal line 543. The column signal processor 550 may include a noise processing section. For example, the noise processing section removes a noise level of a system from the signal read out from the unit cell 539 as a result of photoelectric conversion.

The column signal processor 550 includes, for example, an analog digital converter (ADC). The analog digital converter converts the signal read out from the unit cell 539 or an analog signal subjected to the noise process described above to a digital signal. The ADC includes, for example, a comparator section and a counter section. The comparator section compares the analog signal to be converted and a reference signal to be compared with this. The counter section measures a time up to a timing when a result of the comparison by the comparator section is inverted. The column signal processor 550 may include a horizontal scanning circuit section that performs a control of scanning a readout column.

The timing controller 530 supplies signals each controlling a timing to the row driver 520 and the column signal processor 550 on the basis of, for example, a reference clock signal or a timing control signal inputted to the device.

The image signal processor 560 is a circuit that performs various kinds of signal processing on data obtained as a result of photoelectric conversion or data obtained as a result of an imaging operation by the imaging device 1. The image signal processor 560 includes, for example, an image signal processing circuit section and a data holding section. The image signal processor 560 may include a processor section.

Examples of the signal processing executed by the image signal processor 560 include a tone curve correction process in which gradations are increased in a case where the imaging data subjected to the AD conversion is data capturing an image of a dark subject, and gradations are reduced in a case where the imaging data subjected to the AD conversion is data capturing an image of a bright subject. **In** this case, it is desirable to store tone curve characteristic data in advance in the data holding section of the image signal processor 560. The tone curve characteristic data pertains to the tone curve on the basis of which the gradations of the imaging data are corrected.

The input unit 510A is adapted to input, for example, the reference clock signal, the timing control signal, the characteristic data, and the like described above to the imaging device 1 from an outside of the device. Examples of the timing control signal include a vertical synchronization signal, a horizontal synchronization signal, and the like. The characteristic data is to be stored, for example, in the data holding section of the image signal processor 560. The input unit 510A includes, for example, an input terminal 511, an input circuit section 512, an input amplitude change section 513, an input data conversion circuit section 514, and a power supply section (not illustrated).

The input terminal 511 is an external terminal adapted to input data. The input circuit section 512 is adapted to cause a signal inputted to the input terminal 511 to be taken in the imaging device 1. The input amplitude change section 513 changes an amplitude of the signal that has been taken in by the input circuit section 512 into an amplitude that is easy to use inside the imaging device 1. The input data conversion circuit section 514 reorders data strings of input data. The input data conversion circuit section 514 includes, for example, a serial parallel conversion circuit. The serial parallel conversion circuit converts a serial signal received as the input data to a parallel signal. It is to be noted that in the input unit 510A, the input amplitude change section 513 and the input data conversion circuit section 514 may be omitted. The power supply section supplies power set at a variety of voltages necessary inside the imaging device 1 on the basis of power supplied from the outside to the imaging device 1.

In a case where the imaging device 1 is coupled to an external memory device, the input unit 510A may be provided with a memory interface circuit that receives data from the external memory device. Examples of the external memory device include a flash memory, an SRAM, a DRAM, and the like.

The output unit 510B outputs image data to the outside of the device. Examples of the image data include image data captured by the imaging device 1, image data subjected to the signal processing by the image signal processor 560, and the like. The output unit 510B includes, for example, an output data conversion circuit section 515, an output amplitude change section 516, an output circuit section 517, and an output terminal 518.

The output data conversion circuit section 515 includes, for example, a parallel serial conversion circuit. The output data conversion circuit section 515 converts a parallel signal used inside the imaging device 1 into a serial signal. The output amplitude change section 516 changes an amplitude of a signal used inside the imaging device 1. The signal with the changed amplitude is easier to use in the external device coupled to the outside of the imaging device 1. The output circuit section 517 is a circuit that outputs data from an inside of the imaging device 1 to the outside of the device. The output circuit section 517 drives a wiring, outside the imaging device 1, that is coupled to the output terminal 518. The output terminal 518 outputs data from the imaging device 1 to the outside of the device. In the output unit 510B, the output data conversion circuit section 515 and the output amplitude change section 516 may be omitted.

When the imaging device 1 is coupled to the external memory device, the output unit 510B may be provided with a memory interface circuit that outputs data to the external memory device. Examples of the external memory device include a flash memory, an SRAM, a DRAM, and the like.

### [Schematic Configuration of Imaging Device]

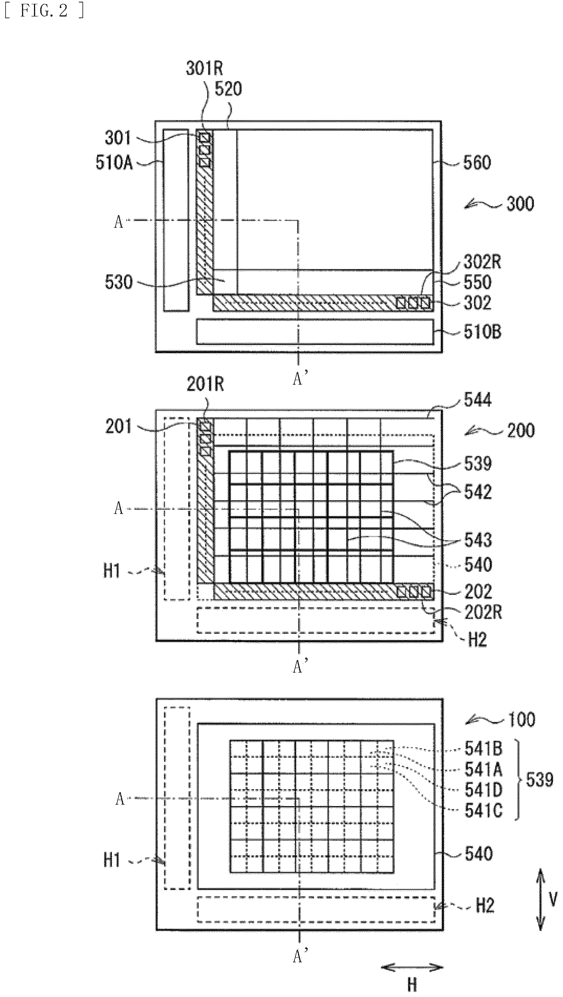

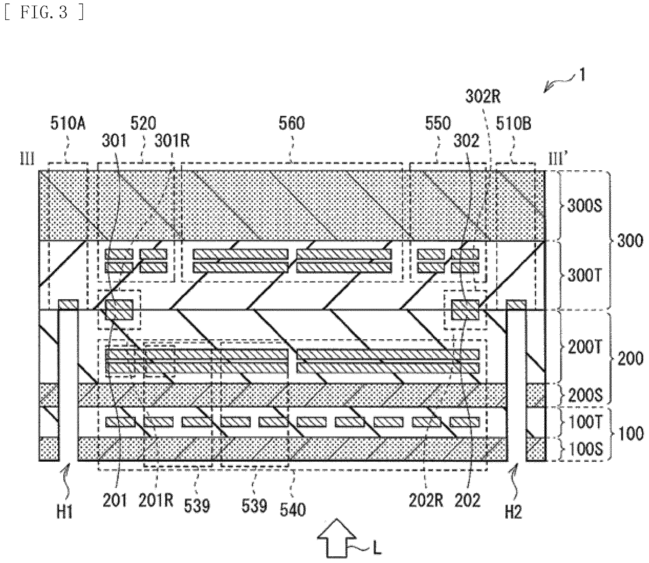

FIGs. 2 and 3 each illustrate an example of a schematic configuration of the imaging device 1. The imaging device 1 includes three substrates (a first substrate 100, a second substrate 200, and a third substrate 300). FIG. 2 schematically illustrates respective plan configurations of the first substrate 100, the second substrate 200, and the third substrate 300, and FIG. 3 schematically illustrates a cross-sectional configuration of the first substrate 100, the second substrate 200, and the third substrate 300 that are stacked on each other. FIG. 3 corresponds to a cross-sectional configuration along a line A-A' illustrated in FIG. 2. The imaging device 1 is an imaging device that has a three-dimensional structure in which the three substrates (the first substrate 100, the second substrate 200, and the third substrate 300) are bonded together. The first substrate 100 includes a semiconductor layer 100S and a wiring layer 100T. The second substrate 200 includes a semiconductor layer 200S and a wiring layer 200T. The third substrate 300 includes a semiconductor layer 300S and a wiring layer 300T. Here, a wiring included in each of the first substrate 100, the second substrate 200, and the third substrate 300 and an interlayer insulating film around the wiring are collectively referred to as a wiring layer (100T, 200T, or 300T) provided in corresponding one of the substrates (the first substrate 100, the second substrate 200, and the third substrate 300) for convenience. The first substrate 100, the second substrate 200, and the third substrate 300 are stacked in this order. The semiconductor layer 100S, the wiring layer 100T, the semiconductor layer 200S, the wiring layer 200T, the wiring layer 300T, and the semiconductor layer 300S are disposed in this order along a stacking direction. Specific configurations of the first substrate 100, the second substrate 200, and the third substrate 300 will be described later. An arrow illustrated in FIG. 3 indicates an entering direction of light L with respect to the imaging device 1. Herein, in cross-sectional diagrams below, light entering side of the imaging device 1 is sometimes referred to as "down", "lower side", or "below", and side opposite to the light entering side is sometimes referred to as "up", "upper side", or "above" for convenience. In addition, herein, regarding a substrate including a semiconductor layer and a wiring layer, wiring layer side is sometimes referred to as a front surface, and the semiconductor layer side is sometimes referred to as a back surface for convenience. It is to be noted that descriptions of the specification are not limited to the wordings described above. The imaging device 1 is, for example, a back-illuminated imaging device in which light enters from back surface side of the first substrate 100 including a photodiode.

The pixel array unit 540 and the unit cell 539 included in the pixel array unit 540 each include both the first substrate 100 and the second substrate 200. The first substrate 100 is provided with the plurality of pixels 541A, 541B, 541C, and 541D included in the unit cell 539. Each of the pixels 541 includes a photodiode (a photodiode PD to be described later) and a transfer transistor (a transfer transistor TR to be described later). The second substrate 200 is provided with a pixel circuit (a pixel circuit 210 to be described later) included in the unit cell 539. The pixel circuit reads out a pixel signal transferred from the photodiode of each of the pixels 541A, 541B, 541C, and 541D via the transfer transistor, or resets the photodiode. The second substrate 200 includes the plurality of row drive signal lines 542 extending in the row direction and the plurality of vertical signal lines 543 extending in the column direction in addition to such a pixel circuit. The second substrate 200 further includes a power supply line 544 extending in the row direction. The third substrate 300 includes, for example, the input unit 510A, the row driver 520, the timing controller 530, the column signal processor 550, the image signal processor 560, and the output unit 510B. The row driver 520 is provided, for example, in a region partially overlapping the pixel array unit 540 in the stacking direction of the first substrate 100, the second substrate 200, and the third substrate 300 (hereinafter, simply referred to as the stacking direction). More specifically, the row driver 520 is provided in a region overlapping, in the stacking direction, the vicinity of an end of the pixel array unit 540 in the H direction (FIG. 2). The column signal processor 550 is provided in, for example, a region partially overlapping the pixel array unit 540 in the stacking direction. More specifically, the column signal processor 550 is provided in a region overlapping, in the stacking direction, the vicinity of an end of the pixel array unit 540 in the V direction. Although not illustrated, the input unit 510A and the output unit 510B may be disposed in a portion other than the third substrate 300. For example, the input unit 510A and the output unit 510B may be disposed in the second substrate 200. Alternatively, the input unit 510A and the output unit 510B may be provided on back surface (light entering surface) side of the first substrate 100. It is to be noted that the pixel circuit provided in the second substrate 200 described above is sometimes alternatively referred to as a pixel transistor circuit, a pixel transistor group, a pixel transistor, a pixel readout circuit, or a readout circuit. Herein, it is referred to as the pixel circuit.

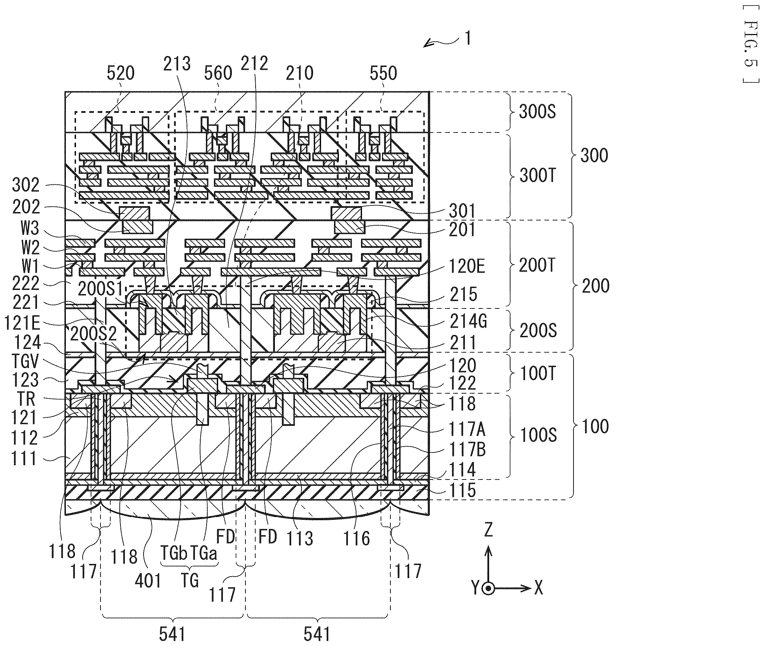

The first substrate 100 and the second substrate 200 are electrically coupled to each other by, for example, a through electrode (e.g., through electrodes 120E and 121E in FIG. 5 to be described later). The second substrate 200 and the third substrate 300 are electrically coupled to each other via, for example, contact parts 201, 202, 301, and 302. The second substrate 200 is provided with the contact parts 201 and 202, and the third substrate 300 is provided with the contact parts 301 and 302. The contact part 201 of the second substrate 200 is in contact with the contact part 301 of the third substrate 300, and the contact part 202 of the second substrate 200 is in contact with the contact part 302 of the third substrate 300. The second substrate 200 includes a contact region 201R provided with a plurality of contact parts 201, and a contact region 202R provided with a plurality of contact parts 202. The third substrate 300 includes a contact region 301R provided with a plurality of contact parts 301, and a contact region 302R provided with a plurality of contact parts 302. The contact regions 201R and 301R are provided between the pixel array unit 540 and the row driver 520 in the stacking direction. In other words, the contact regions 201R and 301R are provided in, for example, a region in which the row driver 520 (the third substrate 300) and the pixel array unit 540 (the second substrate 200) overlap each other in the stacking direction, or a region in the vicinity thereof. Each of the contact regions 201R and 301R is disposed at, for example, an end of such a region in the H direction. In the third substrate 300, for example, the contact region 301R is provided at a position overlapping a portion of the row driver 520, specifically, an end of the row driver 520 in the H direction. The contact parts 201 and 301 couple, for example, the row driver 520 provided in the third substrate 300 and the row drive signal line 542 provided in the second substrate 200 to each other. The contact parts 201 and 301 may couple, for example, the input unit 510A provided in the third substrate 300 and each of the power supply line 544 and a reference electric potential line (a reference electric potential line VSS to be described later) to each other. The contact regions 202R and 302R are provided between the pixel array unit 540 and the column signal processor 550 in the stacking direction. In other words, the contact regions 202R and 302R are provided in, for example, a region in which the column signal processor 550 (the third substrate 300) and the pixel array unit 540 (the second substrate 200) overlap each other in the stacking direction, or a region in the vicinity thereof. Each of the contact regions 202R and 302R is disposed at, for example, an end of such a region in the V direction. In the third substrate 300, for example, the contact region 301R is provided at a position overlapping a portion of the column signal processor 550, specifically, an end of the column signal processor 550 in the V direction. The contact parts 202 and 302 are adapted to couple, for example, respective pixel signals (signals corresponding to an amount of electric charge generated as a result of photoelectric conversion by the photodiodes) outputted from the plurality of unit cells 539 included in the pixel array unit 540 to the column signal processor 550 provided in the third substrate 300. The pixel signals are sent from the second substrate 200 to the third substrate 300.

FIG. 3 is an example of a cross-sectional view of the imaging device 1. The first substrate 100, the second substrate 200, and the third substrate 300 are electrically coupled to each other via the wiring layers 100T, 200T, and 300T. For example, the imaging device 1 includes an electrical coupling section that electrically couples the second substrate 200 and the third substrate 300 to each other. Specifically, the contact parts 201, 202, 301, and 302 each include an electrode including an electrically conductive material. The electrically conductive material includes, for example, a metal material such as copper (Cu), aluminum (Al), or gold (Au). The contact regions 201R, 202R, 301R, and 302R electrically couple the second substrate and the third substrate to each other by, for example, directly bonding wirings formed as electrodes, and make it possible to input and/or output of a signal between the second substrate 200 and the third substrate 300.

The electrical coupling section that electrically couples the second substrate 200 and the third substrate 300 to each other may be provided at a desired location. For example, as described in FIG. 3 as the contact regions 201R, 202R, 301R, and 302R, the electrical coupling section may be provided in a region overlapping the pixel array unit 540 in the stacking direction. Alternatively, the electrical coupling section may be provided in a region that does not overlap the pixel array unit 540 in the stacking direction. Specifically, the electrical coupling section may be provided in a region overlapping, in the stacking direction, a peripheral part positioned outside the pixel array unit 540.

The first substrate 100 and the second substrate 200 are provided with, for example, coupling hole sections H1 and H2. The coupling hole sections H1 and H2 extend through the first substrate 100 and the second substrate 200. The coupling hole sections H1 and H2 are provided outside the pixel array unit 540 (or at respective portions overlapping the pixel array unit 540), as illustrated in FIG. 2. For example, the coupling hole section H1 is disposed outside the pixel array unit 540 in the H direction, and the coupling hole section H2 is disposed outside the pixel array unit 540 in the V direction. For example, the coupling hole section H1 reaches the input unit 510A provided in the third substrate 300, and the coupling hole section H2 reaches the output unit 510B provided in the third substrate 300. Each of the coupling hole sections H1 and H2 may be hollow or may include an electrically conductive material at least in part. For example, there is a configuration in which a bonding wire is coupled to an electrode formed as the input unit 510A and/or the output unit 510B. Alternatively, there is a configuration in which the electrode formed as the input unit 510A and/or the output unit 510B and electrically conductive materials provided in the coupling hole sections H1 and H2 are coupled to each other. The electrically conductive materials provided in the coupling hole sections H1 and H2 may be embedded in a part or all of the coupling hole sections H1 and H2. The electrically conductive materials may be formed on sidewalls of the coupling hole sections H1 and H2.

It is to be noted that FIG. 3 illustrates a structure in which the input unit 510A and the output unit 510B are provided in the third substrate 300, but this is non-limiting. For example, it is made possible to provide the input unit 510A and/or the output unit 510B in the second substrate 200, by sending a signal of the third substrate 300 to the second substrate 200 via the wiring layers 200T and 300T. Similarly, it is made possible to provide the input unit 510A and/or the output unit 510B in the first substrate 100, by sending a signal of the second substrate 200 to the first substrate 100 via the wiring layers 100T and 200T.

The pixels 541A, 541B, 541C, and 541D includes components common to each other. Hereinafter, to distinguish the components of the pixels 541A, 541B, 541C, and 541D from each other, an identification number 1 is attached to an end of a reference sign of the component of the pixel 541A, an identification number 2 is attached to an end of a reference sign of the component of the pixel 541B, an identification number 3 is attached to an end of a reference sign of the component of the pixel 541C, and an identification number 4 is attached to an end of a reference sign of the component of the pixel 541D. In a case where there is no need to distinguish the components of the pixels 541A, 541B, 541C, and 541D from each other, the identification numbers at the ends of the reference signs of the components of the pixels 541A, 541B, 541C, and 541D are omitted.

FIG. 4 is an equivalent circuit diagram illustrating an example of a configuration of the unit cell 539. The unit cell 539 includes the plurality of pixels 541 (in FIG. 4, the four pixels 541A, 541B, 541C, and 541D), one pixel circuit 210 coupled to the plurality of pixels 541, and the vertical signal line 543 coupled to the pixel circuit 210. The pixel circuit 210 includes, for example, four transistors, specifically, an amplification transistor AMP, a selection transistor SEL, a reset transistor RST, and an FD conversion gain switching transistor FDG. As described above, the unit cell 539 is configured to sequentially output respective pixel signals of the four pixels 541 (the pixels 541A, 541B, 541C, and 541D) provided in two adjacent pixels to the vertical signal line 543 by causing the one pixel circuit 210 to operate in a time division manner. The one pixel circuit 210 is coupled to the plurality of pixels 541. A state in which the pixel signals of the plurality of pixels 541 are outputted by the one pixel circuit 210 in the time division manner is referred to as "the plurality of pixels 541 shares the one pixel circuit 210".

The pixels 541A, 541B, 541C, and 541D have components common to each other.

Each of the pixels 541A, 541B, 541C, and 541D includes, for example, the photodiode PD, the transfer transistor TR, and a floating diffusion FD. The transfer transistor TR is electrically coupled to the photodiode PD. The floating diffusion FD is electrically coupled to the transfer transistor TR. The photodiode PD has a cathode electrically coupled to a source of the transfer transistor TR, and has an anode electrically coupled to a reference electric potential line (e.g., ground). The photodiode PD photoelectrically converts entering light and generates electric charge corresponding to a received light amount. The transfer transistor TR is, for example, an n-type CMOS (Complementary Metal Oxide Semiconductor) transistor. The transfer transistor TR has a drain electrically coupled to the floating diffusion FD and has a gate electrically coupled to a drive signal line. This drive signal line is a part of the plurality of row drive signal lines 542 coupled to the one unit cell 539. The transfer transistor TR transfers the electric charge generated by the photodiode PD to the floating diffusion FD. The floating diffusion FD is an n-type diffusion layer region formed in a p-type semiconductor layer. The floating diffusion FD is an electric charge holding means that temporarily holds the electric charge transferred from the photodiode PD and is also an electric charge-voltage conversion means that generates a voltage corresponding to an amount of the electric charge.

The four floating diffusions FD (floating diffusions FD1, FD2, FD3, and FD4) included in the one unit cell 539 are electrically coupled to each other, and are each electrically coupled to a gate of the amplification transistor AMP and a source of the FD conversion gain switching transistor FDG. A drain of the FD conversion gain switching transistor FDG is coupled to a source of the reset transistor RST, and a gate of the FD conversion gain switching transistor FDG is coupled to a drive signal line. The drive signal line is a part of the plurality of row drive signal lines 542 coupled to the one unit cell 539. A drain of the reset transistor RST is coupled to a power supply line VDD, and a gate of the reset transistor RST is coupled to a drive signal line. The drive signal line is a part of the plurality of row drive signal lines 542 coupled to the one unit cell 539. The gate of the amplification transistor AMP is coupled to the floating diffusion FD, a drain of the amplification transistor AMP is coupled to the power supply line VDD, and a source of the amplification transistor AMP is coupled to a drain of the selection transistor SEL. A source of the selection transistor SEL is coupled to the vertical signal line 543, and a gate of the selection transistor SEL is coupled to a drive signal line. The drive signal line is a part of the plurality of row drive signal lines 542 coupled to the one unit cell 539.

When the transfer transistor TR is turned on, the transfer transistor TR transfers the electric charge of the photodiode PD to the floating diffusion FD. A gate (a transfer gate TG) of the transfer transistor TR includes, for example, what is called a vertical electrode and is provided to extend from the front surface of the semiconductor layer (the semiconductor layer 100S in FIG. 5 to be described later) to a depth of the PD. The reset transistor RST resets an electric potential of the floating diffusion FD to a predetermined electric potential. When the reset transistor RST is turned on, the reset transistor RST resets the electric potential of the floating diffusion FD to an electric potential of the power supply line VDD. The selection transistor SEL controls an output timing of the pixel signal from the pixel circuit 210. The amplification transistor AMP generates, as a pixel signal, a signal of a voltage corresponding to a level of the electric charge held in the floating diffusion FD. The amplification transistor AMP is coupled to the vertical signal line 543 via the selection transistor SEL. The amplification transistor AMP is included in a source follower in the column signal processor 550, together with the load circuit section coupled to the vertical signal line 543. When the selection transistor SEL is turned on, the amplification transistor AMP outputs a voltage of the floating diffusion FD to the column signal processor 550 via the vertical signal line 543. The reset transistor RST, the amplification transistor AMP, and the selection transistor SEL are each an N-type CMOS transistor, for example.

The FD conversion gain switching transistor FDG is used to change a gain of electric charge-voltage conversion by the floating diffusion FD. In general, a pixel signal is small in shooting an image in a dark place. On the basis of Q = CV, when the electric charge-voltage conversion is performed, the floating diffusion FD having a larger capacitance (FD capacitance C) results in smaller V when conversion to a voltage is performed by the amplification transistor AMP. In contrast, a bright place results in a larger pixel signal. It is therefore not possible for the floating diffusion FD to completely receive the electric charge of the photodiode PD unless the FD capacitance C is large. Further, the FD capacitance C has to be large to prevent V when the conversion to a voltage is performed by the amplification transistor AMP from being too large (i.e., to make V small). Taking these into consideration, when the FD conversion gain switching transistor FDG is turned on, the gate capacitance for the FD conversion gain switching transistor FDG is increased. This causes the FD capacitance C as a whole to be large. In contrast, when the FD conversion gain switching transistor FDG is turned off, the FD capacitance C as a whole becomes small. In this way, switching the FD conversion gain switching transistor FDG between on and off allows the FD capacitance C to be variable, and makes it possible to switch conversion efficiency. The FD conversion gain switching transistor FDG is, for example, an N-type CMOS transistor.

It is to be noted that a configuration is also possible in which the FD conversion gain switching transistor FDG is not provided. In this case, for example, the pixel circuit 210 includes, for example, the three transistors, which are the amplification transistor AMP, the selection transistor SEL, and the reset transistor RST. The pixel circuit 210 includes, for example, at least one of pixel transistors including, without limitation, the amplification transistor AMP, the selection transistor SEL, the reset transistor RST, and the FD conversion gain switching transistor FDG.

The selection transistor SEL may be provided between the power supply line VDD and the amplification transistor AMP. In this case, the drain of the reset transistor RST is electrically coupled to the power supply line VDD and the drain of the selection transistor SEL. The source of the selection transistor SEL is electrically coupled to the drain of the amplification transistor AMP, and the gate of the selection transistor SEL is electrically coupled to the row drive signal line 542. The source of the amplification transistor AMP (an output end of the pixel circuit 210) is electrically coupled to the vertical signal line 543, and the gate of the amplification transistor AMP is electrically coupled to the source of the reset transistor RST. It is to be noted that, although not illustrated, the number of the pixels 541 that share the one pixel circuit 210 may be a number other than 4. For example, two or eight pixels 541 may share the one pixel circuit 210.

### [Cross-Sectional Configuration of Imaging Device]

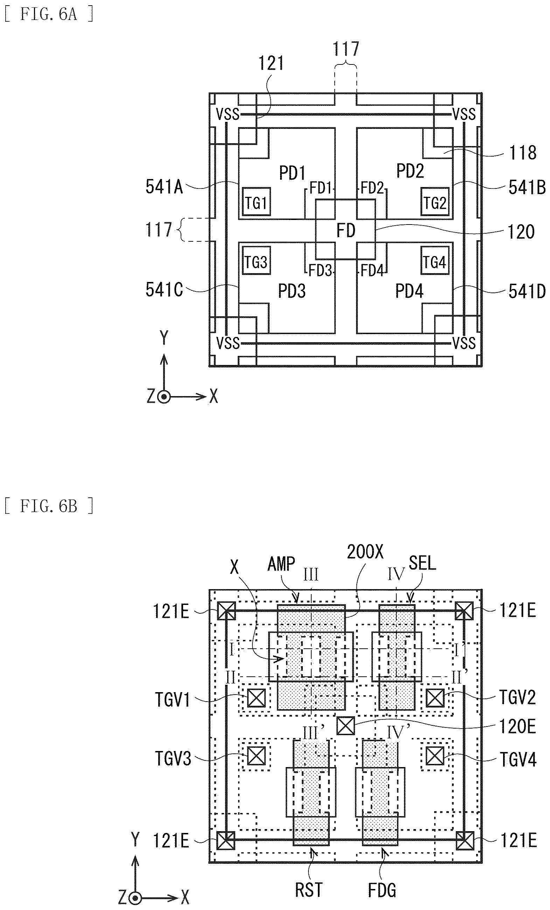

FIG. 5 illustrates an example of a cross-sectional configuration of the first substrate 100, the second substrate 200, and the third substrate 300 of the imaging device 1 in a direction perpendicular to a principal surface. FIG. 5 schematically illustrates a cross-section to allow for easy understanding of a positional relationship among components, and may be different from an actual cross-section. FIG. 6A schematically illustrates an example of a plan layout of the first substrate 100. FIG. 6B schematically illustrates an example of a plan layout of the second substrate 200. In the imaging device 1, the first substrate 100, the second substrate 200, and the third substrate 300 are stacked in this order. The imaging device 1 further includes a light receiving lens 401 on the back surface side (the light entering surface side) of the first substrate 100. For example, a color filter layer (not illustrated) may be provided between the light receiving lens 401 and the first substrate 100. The light receiving lens 401 is provided for, for example, each of the pixels 541A, 541B, 541C, and 541D. The imaging device 1 is, for example, a back-illuminated imaging device. The imaging device 1 includes the pixel array unit 540 disposed at a middle part and a peripheral part (not illustrated) disposed outside the pixel array unit 540.

The first substrate 100 includes the semiconductor layer 100S and the wiring layer 100T in order from the light receiving lens 401 side. The semiconductor layer 100S includes, for example, a silicon substrate. The photodiode PD is formed to be embedded in the semiconductor layer 100S. Specifically, the semiconductor layer 100S includes, for example, a p-well layer 112 in a portion of the front surface (the surface on the wiring layer 100T side) and in the vicinity thereof, and includes an n-type semiconductor region 111 in a region (a region deeper than the p-well layer 112) other than that. For example, the n-type semiconductor region 111 and the p-well layer 112 form a pn junction photodiode PD. The p-well layer 112 is a p-type semiconductor region. Here, the semiconductor layer 100S corresponds to one specific example of a "second semiconductor layer" in one embodiment of the present disclosure.

The floating diffusion FD and a VSS contact region 118 are provided in the vicinity of the front surface of the semiconductor layer 100S. The floating diffusion FD includes an n-type semiconductor region provided in the p-well layer 112. The respective floating diffusions FD (the floating diffusions FD1, FD2, FD3, and FD4) of the pixels 541A, 541B, 541C, and 541D are provided, for example, in proximity to each other at a middle part of the unit cell 539, as illustrated in FIG. 6A. The four floating diffusions FD (the floating diffusions FD1, FD2, FD3, and FD4) included in the unit cell 539 are electrically coupled to each other in the first substrate 100 (more specifically, in the wiring layer 100T) via an electrical coupling means (a pad part 120 to be described later). Further, each of the floating diffusions FD is coupled from the first substrate 100 to the second substrate 200 (more specifically, from the wiring layer 100T to the wiring layer 200T) via an electrical means (the through electrode 120E to be described later). In the second substrate 200 (more specifically, inside the wiring layer 200T), the electrical means electrically couples each of the floating diffusions FD to the gate of the amplification transistor AMP and the source of the FD conversion gain switching transistor FDG.

The VSS contact region 118 is a region that is electrically coupled to the reference electric potential line VSS, and is disposed to be separated away from the floating diffusions FD. For example, in each of the pixels 541A, 541B, 541C, and 541D having respective square shapes, the floating diffusion is disposed at one corner, and the VSS contact region 118 is disposed at an opposite corner on a diagonal line. The VSS contact region 118 includes, for example, a p-type semiconductor region. The VSS contact region 118 is coupled to, for example, a ground electric potential or a fixed electric potential. This supplies the semiconductor layer 100S with a reference electric potential.

The first substrate 100 is provided with the transfer transistor TR together with the photodiode PD, the floating diffusion FD, and the VSS contact region 118. The photodiode PD, the floating diffusion FD, the VSS contact region 118, and the transfer transistor TR are provided in each of the pixels 541A, 541B, 541C, and 541D. The transfer transistor TR is provided on the front surface side (an opposite side to the light entering surface side, or the second substrate 200 side) of the semiconductor layer 100S. The transfer transistor TR includes the transfer gate TG. The transfer gate TG includes, for example, a horizontal part TGb opposed to the front surface of the semiconductor layer 100S and a vertical part TGa provided in the semiconductor layer 100S. The vertical part TGa extends in a thickness direction of the semiconductor layer 100S. The vertical part TGa has one end in contact with the horizontal part TGb and another end provided in the n-type semiconductor region 111. The transfer transistor TR includes such a vertical transistor. This prevents occurrence of deficient transfer of the pixel signal and makes it possible to improve readout efficiency of the pixel signal.

Note that the transfer transistor TR may include a planar transistor. In this case, for example, the transfer gate TG is provided on the front surface of the semiconductor layer 100S. A gate insulating film is provided between the semiconductor layer 100S and the transfer gate TG.

The semiconductor layer 1008S is provided with a pixel isolator 117 that isolates the pixels 541A, 541B, 541C, and 541D from each other. The pixel isolator 117 is formed to extend in a normal direction of the semiconductor layer 100S (a direction perpendicular to the front surface of the semiconductor layer 100S (in FIG. 5, a Z-axis direction)). The pixel isolator 117 is provided to partition the pixels 541A, 541B, 541C, and 541D from each other. The pixel isolator 117 has, for example, a planar shape of a lattice shape. For example, the pixel isolator 117 electrically and optically isolates the pixels 541A, 541B, 541C, and 541D from each other. The pixel isolator 117 includes, for example, a light shielding film 117A and an insulating film 117B. For example, tungsten (W) or the like is used for the light shielding film 117A. The insulating film 117B is provided between the light shielding film 117A and the p-well layer 112 or the n-type semiconductor region 111. The insulating film 117B includes, for example, silicon oxide (SiO). The pixel isolator 117 has, for example, an FTI (Full Trench Isolation) structure and is provided through the semiconductor layer 100S. Although not illustrated, the pixel isolator 117 is not limited to the FTI structure in which the pixel isolator 117 is provided through the semiconductor layer 100S. For example, the pixel isolator 117 may have a DTI (Deep Trench Isolation) structure in which the pixel isolator 117 is not provided through the semiconductor layer 100S. The pixel isolator 117 extends in the normal direction of the semiconductor layer 100S and is formed in a partial region of the semiconductor layer 100S.

The semiconductor layer 100S is provided with, for example, a first pinning region 113 and a second pinning region 116. The first pinning region 113 is provided in the vicinity of the back surface of the semiconductor layer 100S and is disposed between the n-type semiconductor region 111 and a fixed electric charge film 114. The second pinning region 116 is provided on a side surface of the pixel isolator 117, specifically, between the pixel isolator 117 and the p-well layer 112 or the n-type semiconductor region 111. The first pinning region 113 and the second pinning region 116 each include, for example, a p-type semiconductor region.

The fixed electric charge film 114 having negative fixed electric charge is provided between the semiconductor layer 100S and the insulating film 115. An electric field induced by the fixed electric charge film 114 forms the first pinning region 113 of a hole accumulation layer at an interface on light receiving surface (back surface) side of the semiconductor layer 100S. This suppresses occurrence of a dark current due to an interface level on the light receiving surface side of the semiconductor layer 100S. The fixed electric charge film 114 includes, for example, an insulating film having negative fixed electric charge. Examples of a material of the insulating film having the negative fixed electric charge include hafnium oxide, zircon oxide, aluminum oxide, titanium oxide, and tantalum oxide.

The light shielding film 117A is provided between the fixed electric charge film 114 and the insulating film 115. The light shielding film 117A may be provided to be continuous with the light shielding film 117A included in the pixel isolator 117. The light shielding film 117A between the fixed electric charge film 114 and the insulating film 115 is selectively provided at, for example, a position opposed to the pixel isolator 117 in the semiconductor layer 100S. The insulating film 115 is provided to cover the light shielding film 117A. The insulating film 115 includes, for example, silicon oxide.

The wiring layer 100T provided between the semiconductor layer 100S and the second substrate 200 includes the pad parts 120 and 121, a passivation film 122, an interlayer insulating film 123, and a bonding film 124 in this order from the semiconductor layer 100S side. The horizontal part TGb of the transfer gate TG is provided in, for example, the wiring layer 100T. It is to be noted that the wiring layer 100T is not limited to the configuration described above, and it is sufficient that the wiring layer 100T has a configuration including a wiring and an insulating film.

Each of the pad parts 120 and 121 is provided on the front surface of the semiconductor layer 100S, for example, in a selective region thereof with an insulating film (not illustrated) interposed therebetween. The pad part 120 is adapted to couple the respective floating diffusions FD (the floating diffusions FD1, FD2, FD3, and FD4) of the pixels 541A, 541B, 541C, and 541D to each other. The pad part 120 is disposed at, for example, the middle portion of the unit cell 539 in a plan view for each of the unit cells 539. The pad part 120 is provided across the pixel isolator 117, and is disposed to overlap at least a portion of each of the floating diffusions FD1, FD2, FD3, and FD4. Specifically, for example, as illustrated in FIG. 6A, the pad part 120 is provided in a region that overlaps, in a direction perpendicular to the front surface of the semiconductor layer 100S, at least a portion of each of the plurality of floating diffusions FD (the floating diffusions FD1, FD2, FD3, and FD4) sharing the pixel circuit 210 and at least a portion of the pixel isolator 117 formed between the plurality of photodiodes PD (the photodiodes PD1, PD2, PD3, and PD4) sharing the pixel circuit 210.

The pad part 121 is adapted to couple the plurality of VSS contact regions 118 to each other. For example, the VSS contact regions 118 provided in the respective pixels 541C and 541D in one of the unit cells 539 adjacent to each other in the V direction and the VSS contact regions 118 provided in the respective pixels 541A and 541B in another of the unit cells 539 are electrically coupled by the pad part 121. The pad part 121 is provided, for example, across the pixel isolator 117, and is disposed to overlap at least a portion of each of the four VSS contact regions 118. Specifically, the pad part 121 is provided in a region that overlaps, in the direction perpendicular to the front surface of the semiconductor layer 100S, at least a portion of each of the plurality of VSS contact regions 118 and at least a portion of the pixel isolator 117 formed between the plurality of VSS contact regions 118.

Providing the pad part 120 makes it possible to reduce wirings for coupling each of the floating diffusions FD to the pixel circuit 210 (e.g., the gate electrode of the amplification transistor AMP) in the chip as a whole. Similarly, providing the pad part 121 makes it possible to reduce wirings that supply electric potentials to the respective VSS contact regions 118 in the chip as a whole. This makes it possible to reduce the area of the chip as a whole, to suppress electrical interference between wirings in miniaturized pixels, and/or to decrease cost by decreasing the number of parts, for example.

The pad parts 120 and 121 each include, for example, polysilicon (Poly Si), more specifically, doped polysilicon to which an impurity is added. The pad parts 120 and 121 each preferably include an electrically conductive material having high heat resistance such as polysilicon, tungsten (W), titanium (Ti), or titanium nitride (TiN). This makes it possible to form the pixel circuit 210 after the semiconductor layer 200S of the second substrate 200 is bonded to the first substrate 100.

The pad parts 120 and 121 may each include a metal material such as tantalum nitride (TaN), aluminum (Al), or copper (Cu).

The passivation film 122 is so provided, for example, over the entire front surface of the semiconductor layer 100S as to cover the pad parts 120 and 121. The passivation film 122 includes, for example, a silicon nitride (SiN) film. The interlayer insulating film 123 covers the pad parts 120 and 121 with the passivation film 122 interposed therebetween. The interlayer insulating film 123 is provided, for example, over the entire front surface of the semiconductor layer 100S. The interlayer insulating film 123 includes, for example, a silicon oxide (SiO) film. The bonding film 124 is provided on a bonding surface between the first substrate 100 (specifically, the wiring layer 100T) and the second substrate 200. In other words, the bonding film 124 is in contact with the second substrate 200. The bonding film 124 is provided over the entire principal surface of the first substrate 100. The bonding film 124 includes, for example, a silicon nitride film.

The light receiving lens 401 is opposed to the semiconductor layer 100S with the fixed electric charge film 114 and the insulating film 115 interposed therebetween, for example. The light receiving lens 401 is provided at, for example, a position opposed to the photodiode PD of each of the pixels 541A, 541B, 541C, and 541D.

The second substrate 200 includes the semiconductor layer 200S and the wiring layer 200T in this order from the first substrate 100 side. The semiconductor layer 200S includes a silicon substrate. The semiconductor layer 200S is provided with, for example, a well region 211 in a selective region, which will be described later in detail. For example, as illustrated in FIG. 6B, the second substrate 200 is provided with the pixel circuit 210 disposed for each of the unit cells 539. The well region 211 is provided, for example, around an active region 200X of the four transistors included in the pixel circuit 210. The well region 211 corresponds to one specific example of a "second semiconductor region" in one embodiment of the present disclosure, and is a p-type semiconductor region, for example. The pixel circuit 210 is provided, for example, on the front surface side (the wiring layer 200T side) of the semiconductor layer 200S. In the imaging device 1, the second substrate 200 is bonded to the first substrate 100 with the back surface side (the semiconductor layer 200S side) of the second substrate 200 facing the front surface side (the wiring layer 100T side) of the first substrate 100. In other words, the second substrate 200 is bonded to the first substrate 100 in a face-to-back manner. Here, the semiconductor layer 200S corresponds to one specific example of a "first semiconductor layer" in one embodiment of the present disclosure.

The second substrate 200 is provided with an insulation region 212 and an element isolation region 213. The insulation region 212 divides the semiconductor layer 200S. The element isolation region 213 is provided in a portion of the semiconductor layer 200S in the thickness direction.

The insulation region 212 is a region adapted to so provide the through electrodes 120E and 121E and a through electrode TGV that the through electrodes 120E and 121E and the through electrode TGV are insulated from the semiconductor layer 200S. The through electrodes 120E and 121E are adapted to electrically couple the first substrate 100 and the second substrate 200 to each other. In other words, the semiconductor layer 200S is divided by the insulation region 212, and the through electrodes 120E and 121E and the through electrode TGV are disposed in the insulation region 212. The insulation region 212 has a thickness substantially the same as a thickness of the semiconductor layer 200S. The insulation region 212 includes, for example, silicon oxide.

The through electrodes 120E and 121E are provided through the insulation region 212 in the thickness direction. An upper end of each of the through electrodes 120E and 121E is coupled to the wiring (a first wiring layer W1, a second wiring layer W2, and a third wiring layer W3) of the wiring layer 200T. The through electrodes 120E and 121E are each provided through the insulation region 212, the bonding film 124, the interlayer insulating film 123, and the passivation film 122. Lower ends of the through electrodes 120E and 121E are coupled to the pad parts 120 and 121, respectively. The through electrode 120E is adapted to electrically couple the pad part 120 and the pixel circuit 210 to each other. In other words, the through electrode 120E electrically couples the floating diffusion FD of the first substrate 100 to the pixel circuit 210 of the second substrate 200. The through electrode 121E is adapted to electrically couple the pad part 121 and the reference electric potential line VSS of the wiring layer 200T to each other. In other words, the through electrode 121E electrically couples the VSS contact region 118 of the first substrate 100 to the reference electric potential line VSS of the second substrate 200.

The through electrode TGV is provided through the insulation region 212 in the thickness direction. An upper end of the through electrode TGV is coupled to the wirings of the wiring layer 200T. The through electrode TGV is provided through the insulation region 212, the bonding film 124, the interlayer insulating film 123, and the passivation film 122. A lower end of the through electrode TGV is coupled to the transfer gate TG. Such a through electrode TGV is adapted to electrically couple each of the transfer gates TG (the transfer gates TG1, TG2, TG3, and TG4) of the pixels 541A, 541B, 541C, and 541D and the wiring (a portion of the row drive signal line 542) of the wiring layer 200T to each other. In other words, the through electrode TGV electrically couples the transfer gate TG of the first substrate 100 to the wiring TRG of the second substrate 200 and allows a drive signal to be sent to each of the transfer transistors TR (the transfer transistors TR1, TR2, TR3, and TR4).

The element isolation region 213 is provided on the front surface side of the semiconductor layer 200S. The element isolation region 213 has an STI (Shallow Trench Isolation) structure. In the element isolation region 213, the semiconductor layer 200S is partially removed in the thickness direction (a direction perpendicular to a principal surface of the second substrate 200), and a portion where the semiconductor layer 200S is removed is filled with an insulating film. The insulating film includes, for example, silicon oxide. The element isolation region 213 allows for element isolation between the plurality of transistors included in the pixel circuit 210 in accordance with a layout of the pixel circuit 210. The semiconductor layer 200S extends under the element isolation region 213 (in a deep part of the semiconductor layer 200S). In the present embodiment, the well region 211 is selectively formed under the element isolation region 213.

As described above, the pixel circuit 210 includes, for example, four transistors, specifically, the amplification transistor AMP, the selection transistor SEL, the reset transistor RST, and the FD conversion gain switching transistor FDG. As illustrated in FIG. 6B, among the four transistors, the amplification transistor AMP and the selection transistor SEL are provided side by side in an X-axis direction, and the reset transistor RST and the FD conversion gain switching transistor FDG are provided side by side in the X-axis direction. The amplification transistor AMP and the selection transistor SEL that are provided side by side in the X-axis direction are provided in the continuous semiconductor layer 200S. The reset transistor RST and the FD conversion gain switching transistor FDG that are provided side by side in the X-axis direction are provided in the continuous semiconductor layer 200S. Element isolation between the amplification transistor AMP and the selection transistor SEL is achieved by the element isolation region 213. Element isolation between the reset transistor RST and the FD conversion gain switching transistor FDG is achieved by the element isolation region 213. The semiconductor layer 200S in which the amplification transistor AMP and the selection transistor SEL are provided and the semiconductor layer 200S in which the reset transistor RST and the FD conversion gain switching transistor FDG are provided are divided by the insulation regions 212 from each other.

Here, the amplification transistor AMP, the selection transistor SEL, the reset transistor RST, and the FD conversion gain switching transistor FDG each correspond to one specific example of a "first active element" in one embodiment of the present disclosure. In addition, in a case where one of the four transistors described above is regarded as the "first active element", the transistor provided side by side with that transistor and formed in the same semiconductor layer 200S corresponds to a "second active element" in one embodiment of the present disclosure. Specifically, for example, in a case where the amplification transistor AMP is regarded as the "first active element", the selection transistor SEL formed in the same semiconductor layer 200S and provided side by side therewith in the X-axis direction corresponds to the "second active element".

A detailed description is given below of configurations of the amplification transistor AMP, the selection transistor SEL, the reset transistor RST, the FD transfer transistor FDG, and the semiconductor layer 200S provided with these transistors. It is to be noted that in a case where the components of the amplification transistor AMP, the selection transistor SEL, the reset transistor RST, and the FD transfer transistor FDG do not need to be distinguished from each other, they are referred to as pixel transistors.

The amplification transistor AMP, the selection transistor SEL, the reset transistor RST, and the FD transfer transistor FDG each preferably have, for example, a three-dimensional structure such as a fin (Fin) type.

A transistor having the three-dimensional structure refers to a transistor in which a plurality of planes of a gate electrode opposed to a channel are provided, or a transistor in which a curved surface of a gate electrode is provided around a channel. In such a transistor having the three-dimensional structure, when the transistor has the same footprint as a planar transistor, it is possible to increase an effective gate width as compared with in the planar transistor. Therefore, a large amount of current flows through the transistor having the three-dimensional structure, and a transconductance (gm) increases. In the transistor having the three-dimensional structure, it is thus possible to improve an operation speed, as compared with in the planar transistor. In addition, it is also possible to reduce RN (Random Noise). In addition, as compared with the planar transistor, the transistor having the three-dimensional structure is increased in gate area and is therefore decreased in RTS (Random Telegraph Signal) noise.

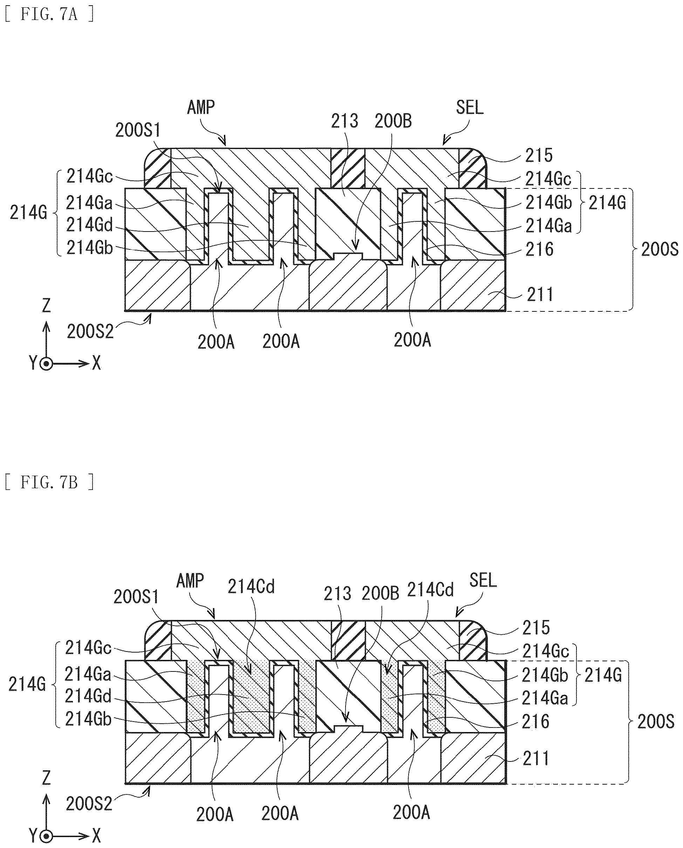

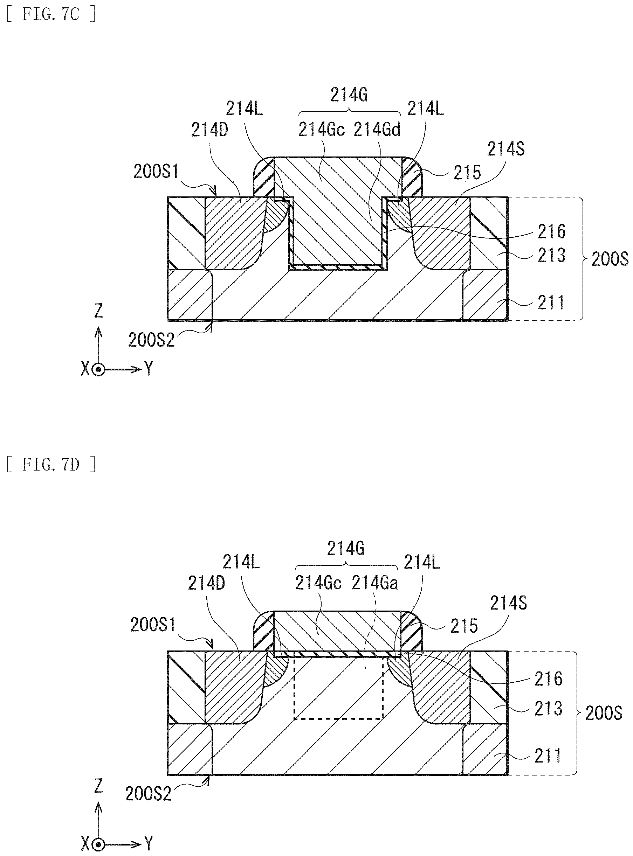

FIG. 7A schematically illustrates a cross-sectional configuration corresponding to a line I-I' illustrated in FIG. 6B. FIG. 7B schematically illustrates a cross-sectional configuration corresponding to a line II-II' illustrated in FIG. 6B. FIG. 7C schematically illustrates a cross-sectional configuration corresponding to a line III-III' illustrated in FIG. 6B. FIG. 7D schematically illustrates a cross-sectional configuration corresponding to a line IV-IV' illustrated in FIG. 6B.

In the present embodiment, each of the pixel transistors, including the amplification transistor AMP, the selection transistor SEL, the reset transistor RST, and the FD transfer transistor FDG, has a fin 200A, a gate electrode 214G, a source region 214S, a drain region 214D, and an LDD (Light Doped Drain) region 214L. The fin 200A extends in one direction. The gate electrode 214G surrounds an upper surface and two sidewalls of the fin 200A. The source region 214S and the drain region 214D are formed at both respective ends of the fin 200A in an extending direction. The LDD region 214L is provided between the gate electrode 214G and the source region 214S, and is provided between the gate electrode 214G and the drain region 214D. In addition, the pixel transistor includes a sidewall 215 and a gate insulating film 216. The sidewall 215 surrounds the gate electrode 214G formed on the semiconductor layer 200S. The gate insulating film 216 is provided between the gate electrode 214G and the semiconductor layer 200S.

The fin 200A is formed by processing the semiconductor layer 200S from front surface 200S 1 side. For example, the fin 200A extends in a Y-axis direction, and includes a sidewall substantially perpendicular to the front surface 200S 1 of the semiconductor layer 200S. In other words, the fin 200A stands in a direction substantially perpendicular to the front surface 200S1 of the semiconductor layer 200S, with a substantially constant width. In the present embodiment, the fin 200A includes the semiconductor layer 200S that is non-doped. Here, "non-doped" refers to a state in which ions for element isolation are not passed. The non-doped region corresponds to one specific example of a "first semiconductor region" in one embodiment of the present disclosure.

It is to be noted that FIGs. 7A and 7B each illustrate an example in which the sidewall of the fin 200A is formed perpendicularly to the front surface 200S 1 of the semiconducting layer 200S; however, a sidewall of a base part of the fin 200A may so form a curved surface that the base part is broaden. This reduces concentration of stress on the base part of the fin 200A, makes it possible to prevent breakage during the manufacturing process, and improves a yield.

The pixel transistor includes one or a plurality of fins 200A. Specifically, for example, the amplification transistor AMP includes two fins 200A provided side by side in the X-axis direction. The selection transistor SEL, the reset transistor RST, and the FD transfer transistor FDG each include one fin 200A.

The gate electrode 214G includes vertical parts 214Ga and 214Gb and a horizontal part 214Gc. The vertical parts 214Ga and 214Gb are provided in the semiconductor layer 200S. The horizontal part 214Gc is opposed to the front surface 200S1 of the semiconductor layer 200S. The vertical parts 214Ga and 214Gb extend in the thickness direction of the semiconductor layer 200S. One end of each of the vertical parts 214Ga and 214Gb is in contact with the horizontal part 214Gc, and another end thereof is provided in the semiconductor layer 200S. Specifically, the gate electrode 214G includes: the vertical parts 214Ga and 214Gb each embedded in the semiconductor layer 200S, along the sidewall of the fin 200A; and the horizontal part 214Gc coupling the vertical part 214Ga and the vertical part 214Gb that are provided side by side in the X-axis direction with the fin 200A interposed therebetween to each other. The vertical part 214Ga correspond to one specific example of a "first electrode part" in one embodiment of the present disclosure, the vertical part 214Gb corresponds to one specific example of a "second electrode part" in one embodiment of the present disclosure, and the horizontal part 214Gc corresponds to one specific example of a "third electrode part" in one embodiment of the present disclosure.

Further, the transistor including two fins 200A, such as the amplification transistor AMP, further includes a vertical part 214Gd between the vertical part 214Ga and the vertical part 214Gb. As with the vertical parts 214Ga and 214Gb, the vertical part 214Gd has one end in contact with the horizontal part 214Gc and another end provided in the semiconductor layer 200S. The vertical part 214Gd corresponds to one specific example of a "fourth electrode part" in one embodiment of the present disclosure.

Further, the active region 200X of the semiconductor layer 200S included in each of the pixel transistors has a cutout part X. Specifically, the cutout part X is provided at a fin 200A portion that is at an outer edge of the active region 200X having a substantially rectangular shape and in which the vertical parts 214Ga and 214Gb of the gate 214 are embedded.

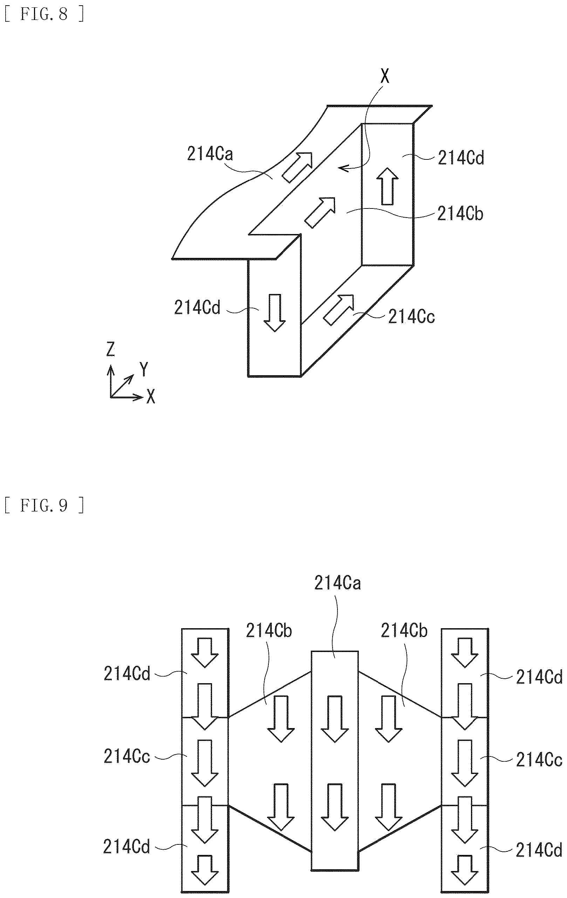

FIG. 8 schematically illustrates channels formed at the cutout part X of the semiconductor layer 200S. FIG. 9 is an exploded view of the channels formed in the cutout part X of the semiconductor layer 200S in the pixel transistor (e.g., the selection transistor SEL) including one fin 200A.

In the present embodiment, for example, as illustrated in FIG. 6B, the horizontal part 214Gc of the gate electrode 214G covers the entire fin 200A extending in the Y-axis direction, and so overhangs as to cover a portion of the source region 214S and the drain region 214D provided at both respective ends of the fin 200A. As a result, channels are formed in the cutout part X. Specifically, as illustrated in FIG. 8 and 9, a surface channel 214Ca is formed in the vicinity of the front surface 200S1 of the semiconductor layer 200S opposed to the horizontal part 214Gc of the gate electrode 214G; a sidewall channel 214Cb is formed at the sidewall of the fin 200A opposed to each of the respective side surfaces of the vertical parts 214Ga and 214Gb of the gate electrode 214G that are opposed to each other; a bottom channel 214Cc is formed at the semiconductor layer 200S opposed to a bottom surface of each of the vertical parts 214Ga and 214Gb; and a transport channel 214Cd is formed at the semiconductor layer 200S opposed to a pair of side surfaces that are opposed in the Y-axis direction, of each of the vertical parts 214Ga and 214Gb (e.g., the semiconductor layer 200S opposed to a hatched portion in FIG. 7B). It is to be noted that, as illustrated in FIG. 9, the sidewall channel 214Cb has a width in the Y-axis direction that narrows from the front surface 200S1 to a back surface 200S2 of the semiconductor layer 200S. This allows a current to flow through the bottom channel 214Cc and the transport channel 214Cd together with the surface channel 214Ca and the sidewall channel 214Cb.

The wiring layer 200T includes, for example, a passivation film 221, an interlayer insulating film 222, and the plurality of wirings (the first wiring layer W1, the second wiring layer W2, and the third wiring layer W3). The passivation film 221 is in contact with the front surface of the semiconductor layer 200S and covers the entire front surface of the semiconductor layer 200S, for example. The passivation film 221 covers the respective gate electrodes of the selection transistor SEL, the amplification transistor AMP, the reset transistor RST, and the FD conversion gain switching transistor FDG. The interlayer insulating film 222 is provided between the passivation film 221 and the third substrate 300. The interlayer insulating film 222 isolates the plurality of wirings (the first wiring layer W1, the second wiring layer W2, and the third wiring layer W3) from each other. The interlayer insulating film 222 includes, for example, silicon oxide.

In the wiring layer 200T, for example, the first wiring layer W1, the second wiring layer W2, the third wiring layer W3, and the contact parts 201 and 202 are provided in this order from the semiconductor layer 200S side, and they are insulated from each other by the interlayer insulating film 222. The interlayer insulating film 222 is provided with a plurality of coupling parts that couples the first wiring layer W1, the second wiring layer W2, or the third wiring layer W3 and a lower layer thereof to each other. Each of the coupling parts is a part in which an electrically conductive material is embedded in a coupling hole provided in the interlayer insulating film 222.

For example, the first wiring layer W1 couples the through electrode 120E and each of the gate of the amplification transistor AMP and the source of the FD conversion gain switching transistor FDG to each other. The first wiring layer W1 couples, for example, the through electrode 121E and the coupling part coupled to the VSS contact region provided in the semiconductor layer 200S to each other, for example. This electrically couples the VSS contact region of the semiconductor layer 200S and the VSS contact region 118 of the semiconductor layer 100S to each other.

The contact parts 201 and 202 may be provided at respective positions overlapping the pixel array unit 540 in a plan view, or may be provided in a peripheral part outside the pixel array unit 540. The contact parts 201 and 202 are provided on the front surface (the surface on the wiring layer 200T side) of the second substrate 200. The contact parts 201 and 202 each include, for example, a metal such as Cu (copper) or Al (aluminum). The contact parts 201 and 202 are exposed at a front surface (a surface on the third substrate 300 side) of the wiring layer 200T. The contact parts 201 and 202 are used to electrically couple the second substrate 200 and the third substrate 300 to each other and to bond the second substrate 200 and the third substrate 300 to each other.

The third substrate 300 includes, for example, the wiring layer 300T and the semiconductor layer 300S in this order from the second substrate 200 side. For example, a front surface of the semiconductor layer 300S is provided on the second substrate 200 side. The semiconductor layer 300S includes a silicon substrate. A portion of such a semiconductor layer 300S on the front surface side is provided with a circuit. Specifically, the portion of the semiconductor layer 300S on the front surface side is provided with, for example, at least a part of the input unit 510A, the row driver 520, the timing controller 530, the column signal processor 550, the image signal processor 560, and the output unit 510B. The wiring layer 300T provided between the semiconductor layer 300S and the second substrate 200 includes, for example, an interlayer insulating film, a plurality of wiring layers separated by the interlayer insulating film, and the contact parts 301 and 302. The contact parts 301 and 302 are exposed from a front surface (a surface on the second substrate 200 side) of the wiring layer 300T. The contact part 301 is in contact with the contact part 201 of the second substrate 200, and the contact part 302 is in contact with the contact part 202 of the second substrate 200. The contact parts 301 and 302 are each electrically coupled to the circuit (e.g., at least any of the input unit 510A, the row driver 520, the timing controller 530, the column signal processor 550, the image signal processor 560, and the output unit 510B) formed in the semiconductor layer 300S. The contact parts 301 and 302 each include, for example, a metal such as Cu (copper) or aluminum (Al). For example, an external terminal is coupled to the input unit 510A via the coupling hole section H1 and an external terminal is coupled to the output unit 510B via the coupling hole section H2.

### [Manufacturing Method of Pixel Transistor]

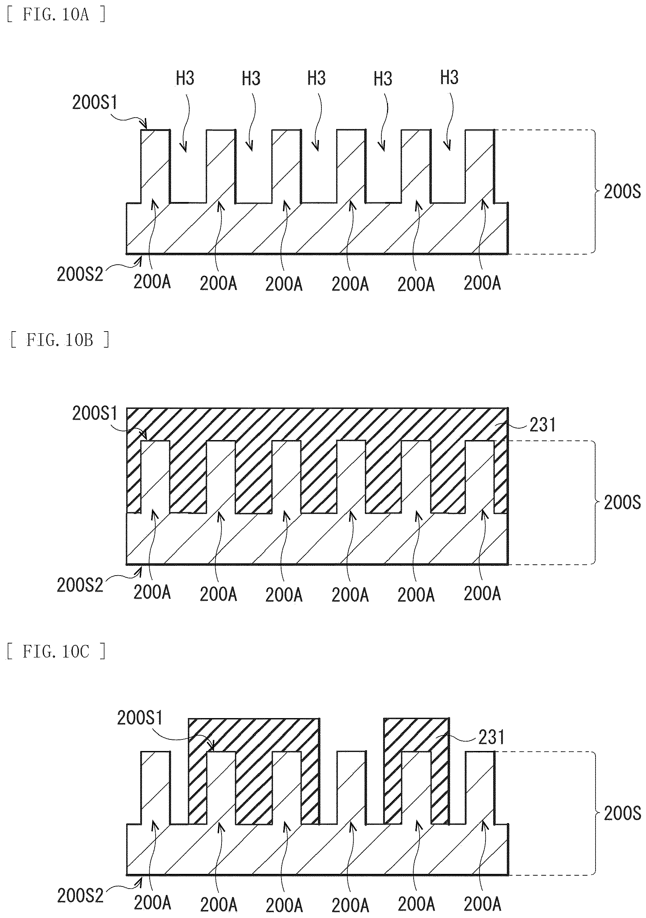

FIGs. 10A to 10J each illustrate an example of a manufacturing method of the pixel transistor illustrated in FIG. 6B, etc.

First, a hard mask is formed on the front surface 200S1 of the semiconductor layer 200S, and photolithography and etching are performed. Thus, for example, as illustrated in FIG. 10A, a plurality of trenches H3 is formed at the front surface 200S1 of the semiconductor layer 200S, and the plurality of fins 200A is formed that stands at equal intervals on the entire front surface 200S1 of the semiconductor layer 200S. As a result, the fins 200A that each have a substantially constant width and stand in a substantially vertical direction are formed at the front surface 200S1 of the semiconductor layer 200S.

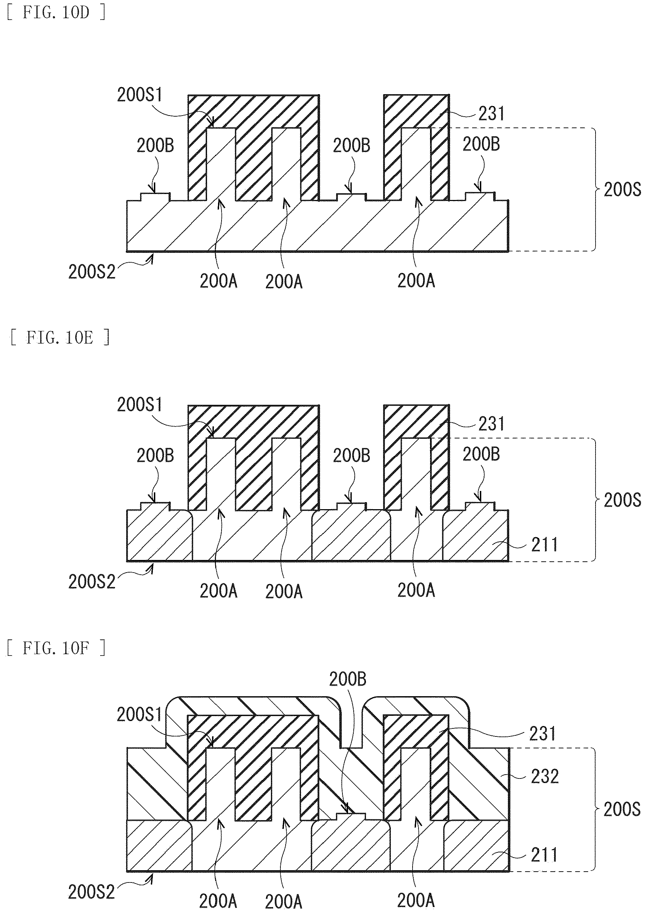

Thereafter, as illustrated in FIG. 10B, for example, a silicon nitride film is so formed, as a hard mask 231, as to fill the trenches H3 between the plurality of fins 200A. Thereafter, a surface of the hard mask 231 is polished and planarized by CMP (Chemical Mechanical Polishing). Thereafter, as illustrated in FIG. 10C, the hard mask 231 is so patterned by photolithography and etching as to protect the active region 200X of the pixel transistor. Thereafter, as illustrated in FIG. 10D, the fin 200A exposed from the hard mask 231 is etched. At this time, a portion of the fin 200A remains, and a protrusion part 200B is thus formed.

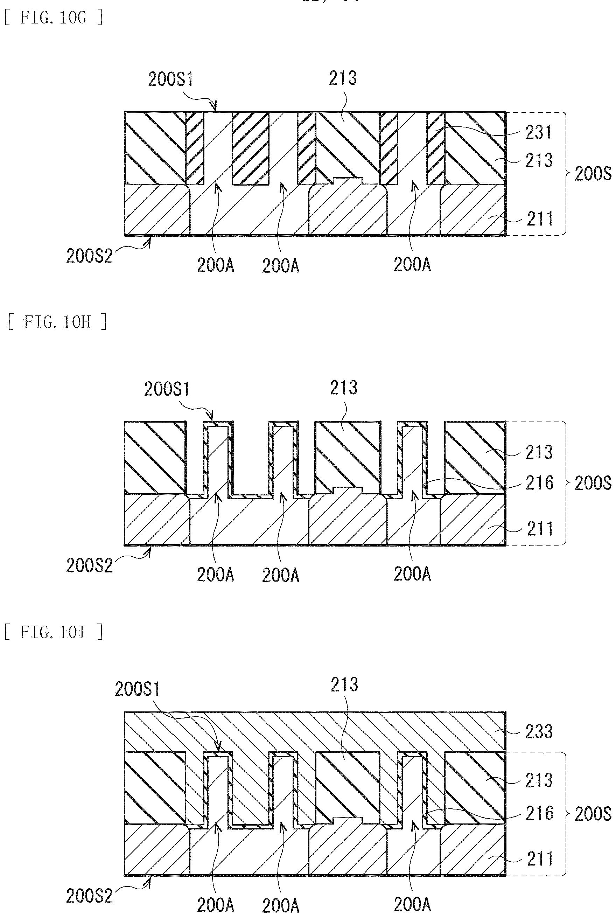

Thereafter, as illustrated in FIG. 10E, a p-type impurity (e.g., boron (B)) is implanted in the semiconductor layer 200S exposed from the hard mask 231 to form the well region 211. The well region 211 is thus formed outside the fin 200A, and the fin 200A in which all of the fin part is non-doped is formed. Thereafter, as illustrated in FIG. 10F, an oxide film 232 is formed on the semiconductor layer 200S by, for example, thermal oxidation. Thereafter, as illustrated in FIG. 10G, the oxide film 232 and the hard mask 231 are polished by CMP to have their surfaces planarized. As a result, an element isolation region 213 that isolates the adjacent pixel transistors from each other is formed. At this time, it is possible for the protrusion part 200B formed in the semiconductor layer 200S to improve adhesion strength between the semiconductor layer 200S and the element isolation region 213 by being fitted with the element isolation region 213.

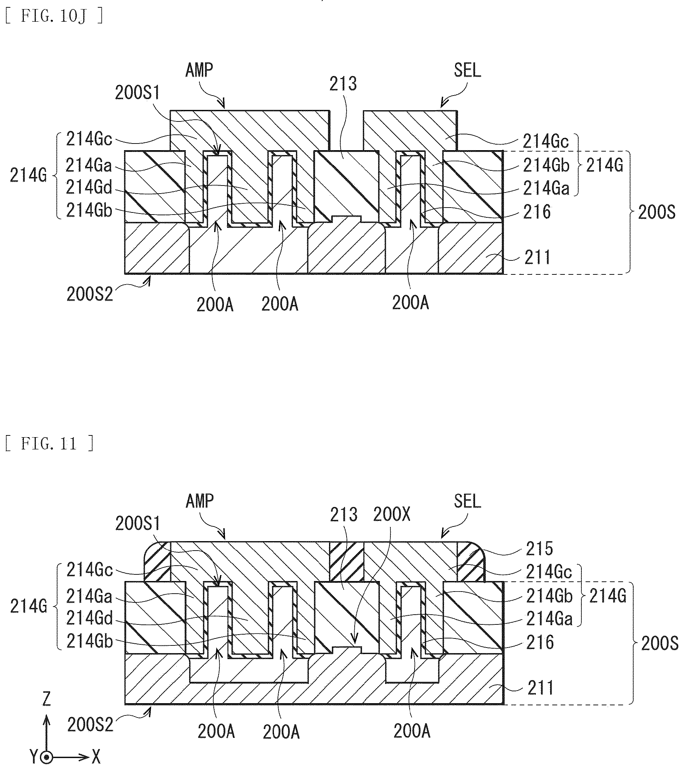

Thereafter, as illustrated in FIG. 10H, for example, the hard mask 231 is removed by a hot phosphoric acid solution, following which the continuous gate insulating film 216 is formed on a side surface and the upper surface of each of the plurality of fins 200A and the surface of the semiconductor layer 200S exposed between the adjacent fins 200A. Thereafter, as illustrated in FIG. 10I, a polysilicon film 233 is so formed as to fill between the adjacent fins 200A and between the fins 200A and the element isolation region 213. Thereafter, as illustrated in FIG. 10J, the polysilicon film 233 is processed. As a result, the gate electrode 214G of the pixel transistor (e.g., each of the amplification transistor AMP and the select transistor SEL) is formed.

Thereafter, an n-type impurity (e.g., phosphorus (P)) is implanted in the active region 200X of the semiconductor layer 200S exposed from the gate electrode 214G to form the LDD region 214L, following which the sidewall 215 is formed on the side surface of the gate electrode 214G. Lastly, an n-type impurity (e.g., arsenic (As)) is implanted at a concentration higher than that for the LDD region 214L to form the source region 214S and the drain region 214D. Thus, the pixel transistor illustrated in FIG. 7A, etc. is completed.

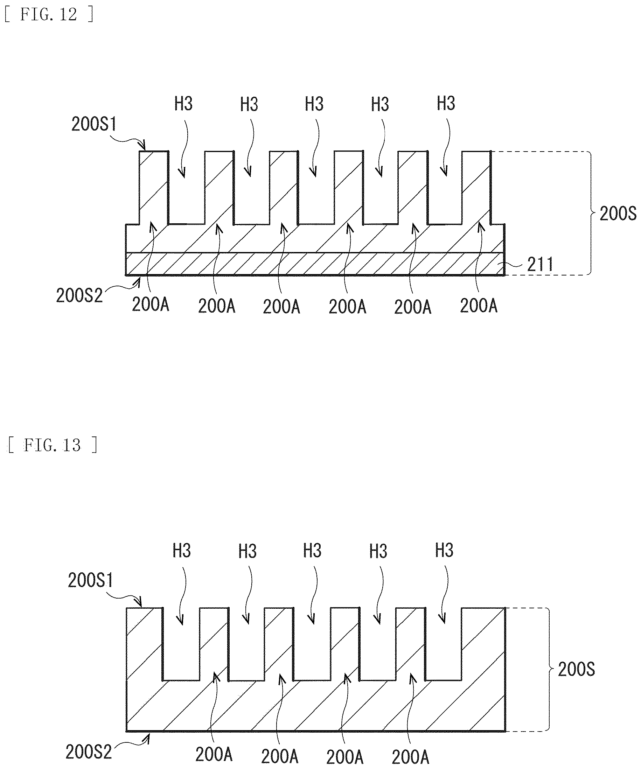

It is to be noted that FIG. 7A, etc. illustrate the example in which the well region 211 is selectively formed only under the element isolation region 213; however, this is non-limiting. For example, as illustrated in FIG. 11, the well region 211 may extend over the entire back surface 200S2 of the semiconductor layer 200S within a range not reaching the base part of the fin 200A. This allows for stabler element isolation. For example, as illustrated in FIG. 12, the well region 211 extending over the entire back surface 200S2 of the semiconductor layer 200S may be formed by implanting a p-type impurity (e.g., boron (B)) from the front surface 200S1 side of the semiconductor layer 200S by ion implantation or the like, before forming the plurality of fins 200A by processing the front surface 200S1 of the semiconductor layer 200S by photolithography and etching.

Further, FIG. 10A illustrates the example in which the plurality of standing fins 200A is formed in the entire front surface 200S1 of the semiconductor layer 200S at equal intervals; however, this is non-limiting. For example, as in the imaging device 1 of the present embodiment, in a case where the photodiode PD and the pixel circuit 210 are provided on different substrates, the plurality of pixel transistors included in the pixel circuit 210 may be densely laid out. Thus, for example, as illustrated in FIG. 13, the trenches H3 may be provided only in a predetermined region to form the plurality of fins 200A. In other words, it is not necessary to form the fin 200A that is a dummy. Densely laying out the plurality of pixel transistors makes it possible to form the fins 200A that stand in the substantially vertical direction with the substantially constant width, without forming the fin 200A to be a dummy.

### [Operation of Imaging Device]

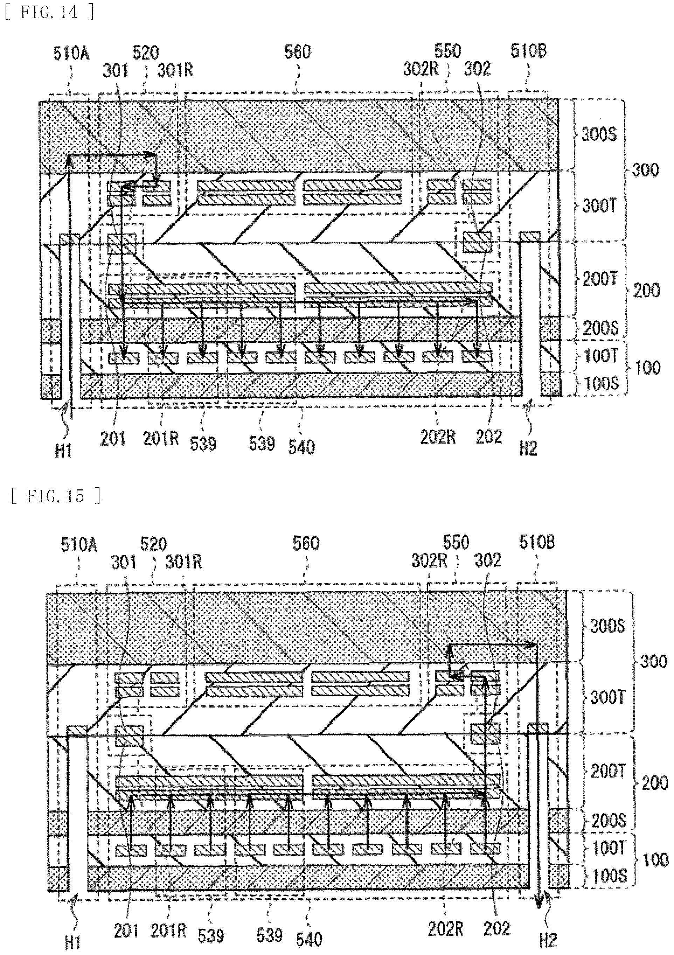

Next, an operation of the imaging device 1 is described with reference to FIGs. 14 and 15. FIGs. 14 and 15 each correspond to FIG. 3 to which an arrow indicating a path of each signal is added. FIG. 14 illustrates, by arrows, paths of an input signal inputted to the imaging device 1 from the outside, a power supply electric potential, and a reference electric potential. FIG. 15 illustrates, by arrows, a signal path of a pixel signal outputted from the imaging device 1 to an outside. For example, an input signal (e.g., a pixel clock and a synchronization signal) inputted to the imaging device 1 via the input unit 510A is transmitted to the row driver 520 of the third substrate 300, and the row driver 520 creates a row drive signal. The row drive signal is sent to the second substrate 200 via the contact parts 301 and 201. Further, the row drive signal reaches each of the unit cells 539 of the pixel array unit 540 via the row drive signal line 542 in the wiring layer 200T. A drive signal other than the drive signal of the transfer gate TG among the row drive signals that have reached the unit cell 539 of the second substrate 200 is inputted to the pixel circuit 210, and each of the transistors included in the pixel circuit 210 is driven. The drive signal of the transfer gate TG is inputted to the transfer gate TG of the first substrate 100, and the pixel 541 is driven. In addition, the power supply electric potential and the reference electric potential supplied to the input unit 510A (the input terminal 511) of the third substrate 300 from the outside of the imaging device 1 are sent to the second substrate 200 via the contact parts 301 and 201, and are supplied to the pixel circuit 210 of each of the unit cells 539 via the wiring in the wiring layer 200T. The reference electric potential is also supplied to the pixel 541 of the first substrate 100. Meanwhile, the pixel signal electrically converted by the pixel 541 of the first substrate 100 is sent to the pixel circuit 210 of the second substrate 200 for each of the unit cells 539. The pixel signal based on this pixel signal is sent to the third substrate 300 from the pixel circuit 210 via the vertical signal line 543 and the contact parts 202 and 302. The pixel signal is outputted to the outside via the output unit 510B after being processed by the column signal processor 550 and the image signal processor 560 of the third substrate 300.

### [Working and Effects]

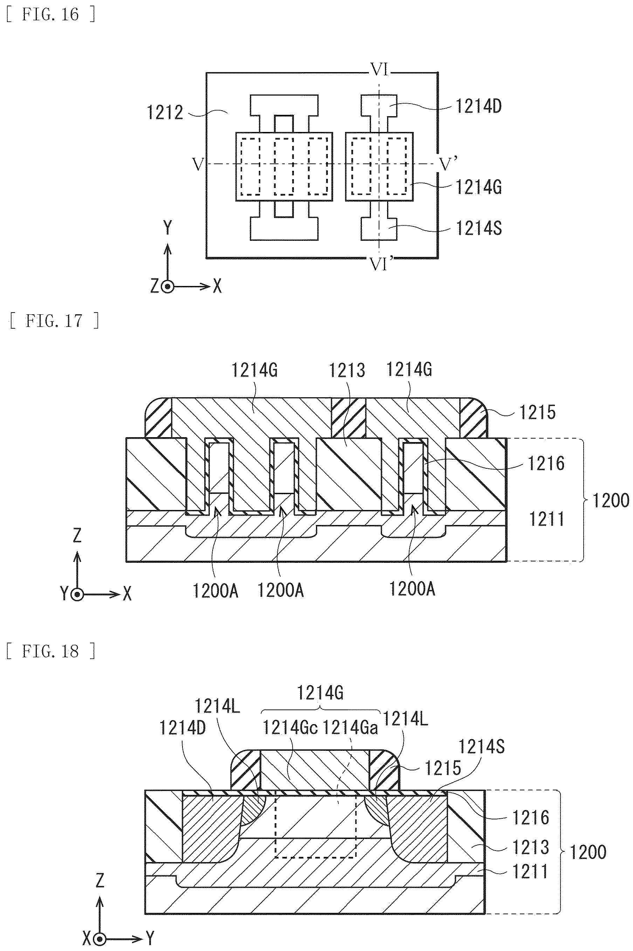

FIG. 16 schematically illustrates a plan configuration of a pixel transistor as Comparative example 1. FIG. 17 schematically illustrates a cross-sectional configuration corresponding to a line V-V' illustrated in FIG. 16. FIG. 18 schematically illustrates a cross-sectional configuration corresponding to a line VI-VI' illustrated in FIG. 16. In a case where MOS transistors disposed side by side are isolated from each other, for example, in a case of N-type transistors, a P-type well 1211 is so formed with no gap as to cover the adjacent transistors of the same type from below an element isolator 1213 having an STI configuration, as illustrated in FIG. 17, for example. This results in formation of a diode between the well 1211 and each of a source region 1214S and a drain region 1214D. Applying a voltage to the well 1211 to prevent the diode from operating makes it possible to prevent a current from flowing between the adjacent transistors. Specifically, for example, a voltage lower than or equal to the lowest voltage among voltages used in the transistors is applied to the P-type well 1211. This makes it possible to prevent a current from flowing from the drain region 1214D having the highest voltage to the source region 1214S of the adjacent transistor.

In a manufacturing process of a typical NMOS transistor, after the element isolator 1213 is processed, for example, a p-type impurity (e.g., boron (B)) is implanted to form the well 1211 over the entire surface of a semiconductor layer 1200. Thereafter, trenches are formed, following which processes are performed including gate processing, LDD injection, sidewall processing, implantation of an n-type impurity (e.g., arsenic (As)) forming the source region and the drain region, and the like. Thus, a transistor having the cross-sectional configuration as illustrated in FIGs. 17 and 18 is formed. In the transistor thus formed, as illustrated in FIGs. 17 and 18, because the P-type well 1211 is formed at a base part of a fin 1200A, a region is generated where a current does not flow easily even if channels are inverted. For example, when gm of a planar NMOS transistor is 1, even if a fin-type transistor in which a channel length (L)/a channel width (W) is designed so that gm is to be 1.6 times is fabricated, gm of the fin-type transistor fabricated by the above-described method becomes 1.4. In addition, due to that the base part of the fin 1200A does not contribute as a channel, an RTS (Random Telegraph Signal) noise is not improved as much as expected.

In contrast, in the imaging device 1 of the present embodiment, in the pixel transistor having the fin-type three-dimensional structure, the non-doped semiconductor layer 200S is used to form the entire fin 200A formed between the vertical parts 214Ga and 214Gb included in the gate electrode 214G. This makes it possible to use the entire fin 200A as a channel region. It is therefore possible to improve gm, as compared with a typical fin-type transistor. In addition, it is possible to improve an RTS noise.

As described above, in the imaging device 1 of the present embodiment, it is possible to improve a device characteristic, as compared with an imaging device including the typical fin-type pixel transistor.

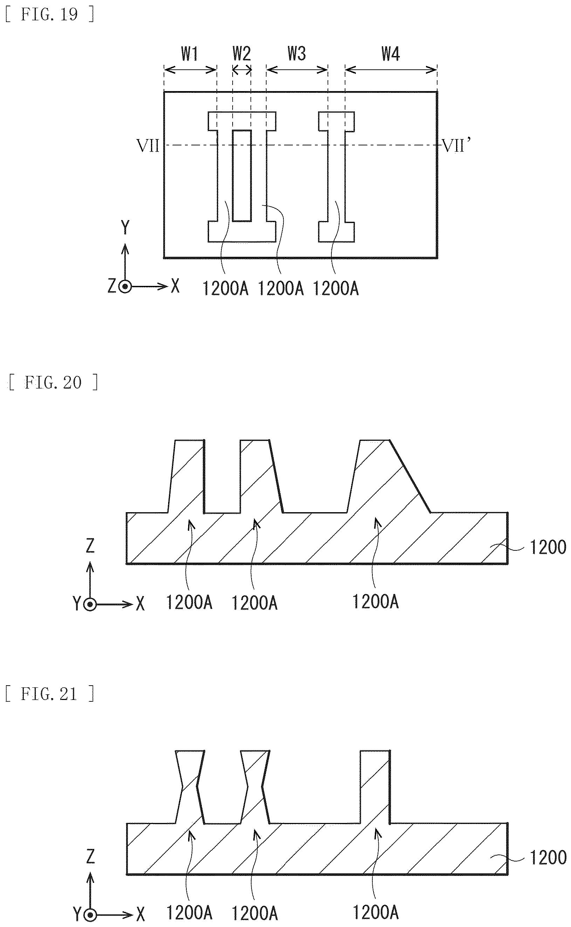

FIG. 19 schematically illustrates an example of a plan layout of a plurality of fins 1200A. FIG. 20 schematically illustrates an example of a cross-sectional shape of each of the fins 1200A when the fins 1200A are formed by etching on the basis of the plan layout illustrated in FIG. 19. FIG. 20 schematically illustrates another example of the cross-sectional shape of each of the fins 1200A when the fins 1200A are formed by etching on the basis of the plan layout illustrated in FIG. 19. For example, in a case where the plurality of fins 1200A having the plan layout illustrated in FIG. 19 is formed by anisotropic etching, a side surface of the fin 1200A is tapered. Anisotropic dry etching allows for vertical processing by a balance between redeposition of a reaction product of an etching gas and a material-to-be-etched, and etching. However, in a case where etching areas are different in the periphery, a difference between the etching areas changes the balance between the deposition of the reaction product and the etching.

As illustrated in FIG. 19, in the layout in which a spacing between the adjacent fins 1200A is greater in order of W2 < W1 < W3 < W4, for example, in a case where a flow rate and a pressure of the etching gas, a voltage of an electrode, etc. are adjusted to allow the respective sidewalls of the fins 1200A adjacent to each other with the spacing W2 to be vertical, it is possible to vertically process the respective sidewalls of the fins 1200A adjacent to each other with the spacing W2, but the sidewalls of other parts are tapered in accordance with the spacings, as illustrated in FIG. 20. In addition, in a case where the flow rate and the pressure of the etching gas, the voltage of the electrode, etc. are adjusted to allow the sidewalls of the fin 1200A between the spacing W3 and the spacing W4 to be vertical, the sidewalls of the fins 1200A disposed with a spacing smaller than the spacing W3 or W4 are excessively etched, and such fins 1200A are each caused to have a bowing cross-sectional shape, as illustrated in FIG. 21. In a case where the gate insulating film is formed on a surface of the fin 1200A having the bowing cross-sectional shape, the gate insulating film formed at a recessed portion becomes extremely thin, which can cause decreased durability, breakdown, etc.

To address this, a possible method may be to dispose dummy fins to allow the spacings between the adjacent fins to be equal and uniformize the etching areas in the periphery. However, in a case where through electrodes are disposed in the periphery as in the imaging device 1 of the present embodiment, it is not easy to dispose the dummy fins. For such a reason, the solid-state imaging device described above employs the shape of the vertical gate electrode part in which a fin width narrows in the depth direction of the semiconductor substrate. However, because the fin width at the base part is wide, the pitches of the transistors are accordingly limited by the fin width at the base part. This leads to an issue of an increase in size of the transistor. In addition, etching conditions have to be considered for each layout to prevent the fin from having the bowing cross-sectional shape.

In the imaging device 1 of the present embodiment, as described above, the plurality of fins 120A and the active region 120X are processed separately. Specifically, as illustrated in FIG. 10A, the trenches H3 are formed to allow the plurality of fins 200A, including the dummy fin 200A, are provided at equal intervals, following which the dummy fin 200A is selectively removed to form the element isolation region 213. This allows the sidewalls of all of the fins 200A to be processed substantially vertically. Accordingly, it is possible to reduce the size of the transistor in the width direction (the X-axis direction) of the fin 200A and to thereby improve area efficiency. In addition, the width of each of the trenches H3 for forming the fins 200A is substantially constant. It is therefore possible to reduce a time for considering the etching conditions. In addition, the sidewalls of the fin 200A being substantially vertical makes it possible to improve short channel effects (SCE).

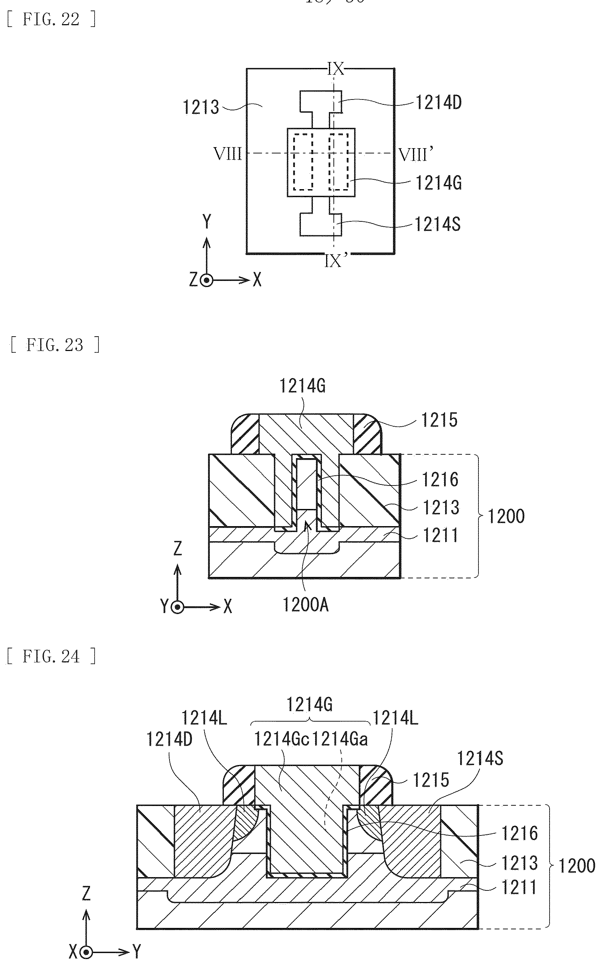

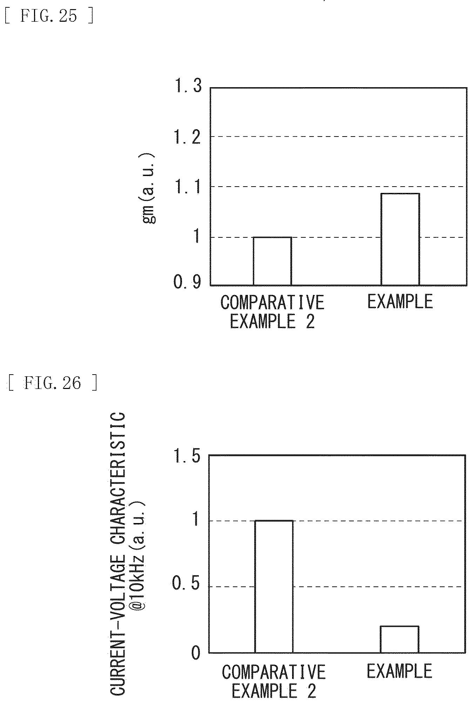

FIG. 22 schematically illustrates a plan configuration of a pixel transistor as Comparative example 2. FIG. 23 schematically illustrates a cross-sectional configuration corresponding to a line VIII-VIII' illustrated in FIG. 22. FIG. 24 schematically illustrates a cross-sectional configuration corresponding to a line IX-IX' illustrated in FIG. 22. FIG. 25 illustrates respective transconductances (gm) of Comparative example 2 and Example. FIG. 26 illustrates respective current-voltage characteristics of Comparative example 2 and Example. When an embedded part of the gate electrode 1214G is not tapered as illustrated in FIG. 23, a channel is formed at a bottom surface of the embedded gate electrode 1214G. However, because the element isolator 1213 is present at each of both ends of the channel at the bottom surface, a current does not flow even if the channel is inverted. In addition, if the depth of the fin 1200A is to be increased (for example, to 200 nm), and the source region 1214S and the drain region 1214D are to be formed down to a depth corresponding to the base part of the fin 1200A, an impurity is diffused into a vertical channel part. This results in a transistor that is not able to be turned off. Generally, the limit of the depth of the source region 1214S and the drain region 1214D is about 100 nm to 150 nm, and an impurity concentration is lowered in a part deeper than this. Therefore, in the vertical channel part of the fin 1200A having the depth more than the depth from 100 nm to 150 nm, the resistance of the source region 1214S and the drain region 1214D is increased and a current does not flow much.

In contrast, in the imaging device 1 of the present embodiment, the cutout part X is formed at the outer edge of the active region 200X having the substantially rectangular shape, the vertical parts 214Ga and 214Gb of the gate 214 are formed at the cutout part X, and the horizontal part 214Gc is caused to so overhang as to cover a portion of the source region 214S and a portion of the drain region 214D. Thus, the sidewall channel 214Cb, the bottom channel 214Cc, and the transport channel 214Cd are formed at the cutout part X, in addition to the surface channel 214Ca. Accordingly, as illustrated in FIGs. 25 and 26, it is possible to provide a transistor that is increased in gm even if the area of the transistor is the same and that has a superior current-voltage characteristic, as compared with the above-described transistor (Comparative example 2), as illustrated in FIGs. 25 and 26.

A description is given below of Modification examples 1 and 2 of the present disclosure, application examples, and practical application examples. In the following, components similar to those in the embodiment described above are denoted with the same reference signs, and descriptions thereof are omitted where appropriate.

### [2. Modification Examples]

### [2-1. Modification Example 1]

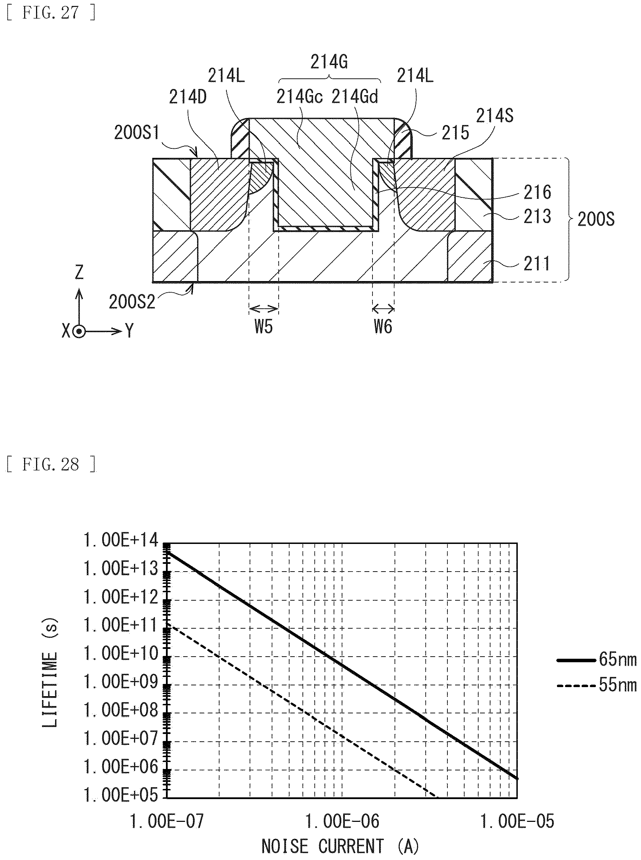

FIG. 27 schematically illustrates a cross-sectional configuration of a pixel transistor according to Modification example 1 of the present disclosure.

In the embodiment described above, the example has been described in which the width of the horizontal part 214Gc, which is included in the gate electrode 214G, overhanging on the source region 214S side and the width of the horizontal part 214Gc overhanging on the drain region 214D side are the same as each other; however, this is non-limiting. In the present modification example, as illustrated in FIG. 27, the width (W5) of the horizontal part 214Gc, which is included in the gate electrode 214G, overhanging on the drain region 214D side is set to be greater than the width (W6) of the horizontal part 214Gc overhanging on the source region 214S side (W5> W6).

An NMOS transistor has an issue in which a current value decreases due to an increase in threshold voltage, a decrease in mobility, or the like caused by occurrence of a hot carrier injection (HCI) phenomenon. As a countermeasure against this, the LDD region is formed so as not to increase an electric field on the drain side, following which the sidewall is formed around the gate electrode, and the source region and the drain region having a higher impurity concentration than the LDD region are formed. FIG. 28 illustrates a relationship between a noise current (Isub) and a lifetime based on a sidewall width. It reveals that if the sidewall width is reduced to reduce the footprint, the lifetime is shortened.

In contrast, in the present modification example, the horizontal part 214Gc included in the gate electrode 214G is caused to overhang more on the drain region 214D side to which a high voltage is applied. The horizontal part 214Gc overhanging on the drain region 214D side makes it possible to achieve effects similar to those achieved by the formation of the sidewall 215. Specifically, causing the horizontal part 214Gc to overhang greatly on the drain region 214D side secures a distance between the drain region 214D and a channel end. This makes it possible to relax the electric field at the end of the gate electrode 142G. In addition, it is possible to sufficiently secure a region to form the LDD region 214L relaxing the electric field, between the drain region 214D and the channel region.

Accordingly, it is possible to reduce the size of the transistor in a direction (the Y-axis direction) in which a current flows, without sacrificing the lifetime.

### [2-2. Modification Example 2]

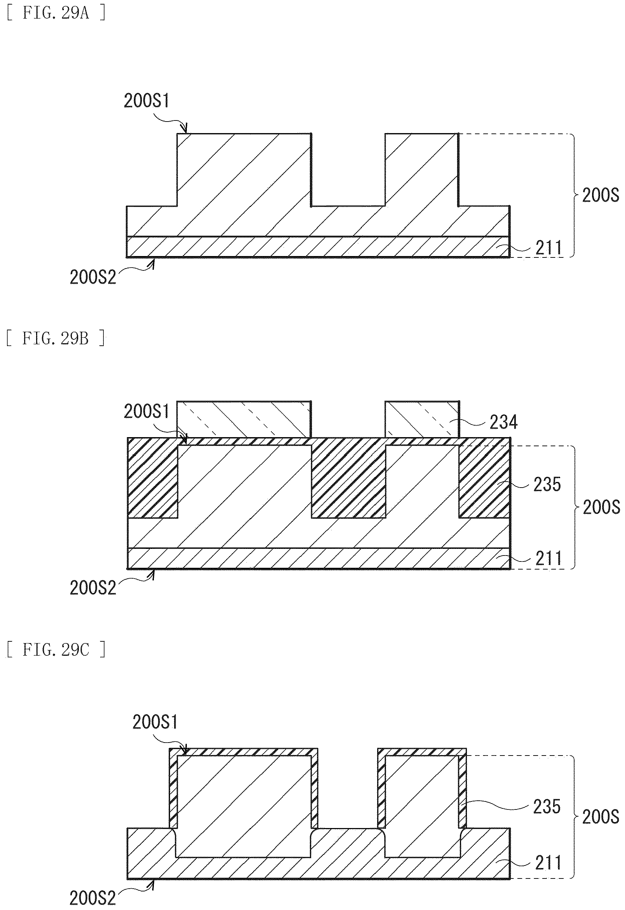

FIGs. 29A to 29K each illustrate an example of a manufacturing method of a pixel transistor according to Modification example 2 of the present disclosure.

First, as illustrated in FIG. 29A, the semiconductor layer 200S in which the well region 211 is formed in advance is subjected to photolithography and etching to process the semiconductor layer 200S except for the active region. Thereafter, as illustrated in FIG. 29B, a silicon nitride film (a SiN film) 235 is formed and a surface thereof is planarized by CMP, following which a hard mask 234 is patterned by a lithography technique. Thereafter, as illustrated in FIG. 29C, the SiN film 235 is etched, following which a p-type impurity (e.g., boron (B)) is implanted in the semiconductor layer 200S exposed from the SiN film 235 to allow the well region 211 to extend.

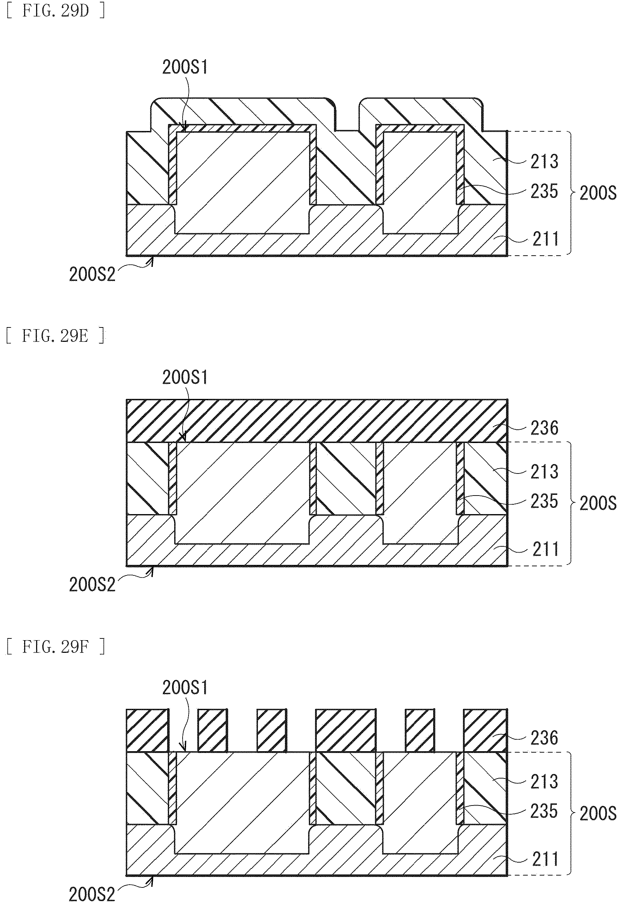

Thereafter, as illustrated in FIG. 29D, an oxide film to be the element isolation region 213 is formed on the semiconductor layer 200S by, for example, thermal oxidation. Thereafter, as illustrated in FIG. 29E, the oxide film to be the element isolation region 213 and the SiN film 235 are polished and surfaces thereof are planarized by CMP, following which a hard mask 236 is formed. As the hard mask 236, for example, an oxide film or a multi-layered film in which a silicon nitride film is stacked on an oxide film, etc. may be used. Thereafter, as illustrated in FIG. 29F, the hard mask 236 is patterned by a lithography technique.

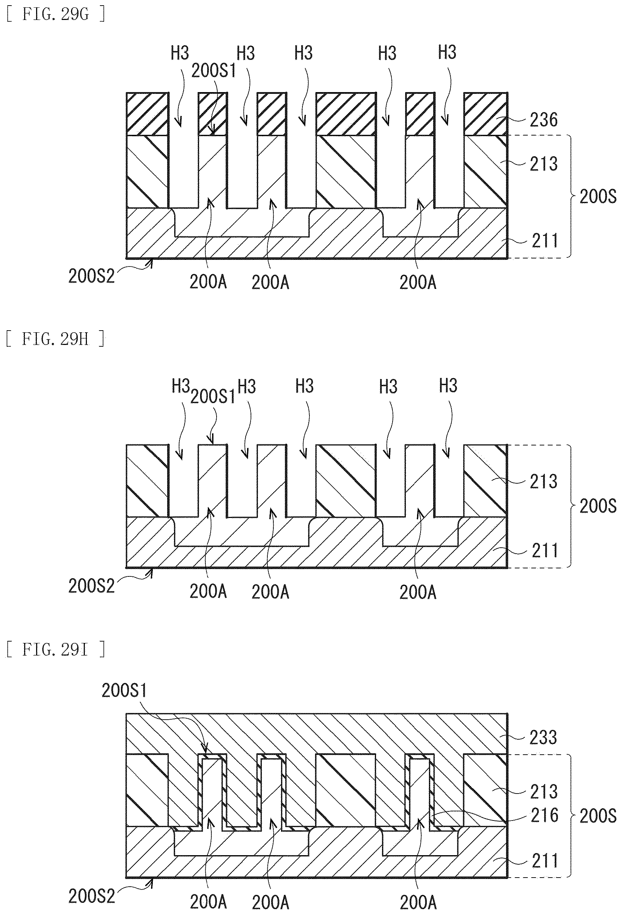

Thereafter, as illustrated in FIG. 29G, the semiconductor layer 200S exposed from the hard mask 236 is etched to form the trenches H3 having the same widths. The plurality of fins 200A is thus formed. Thereafter, as illustrated in FIG. 29H, the hard mask 236 is removed by a hot phosphoric acid solution. Thereafter, as illustrated in FIG. 29I, the continuous gate insulating film 216 is formed on the side surface and the upper surface of each of the plurality of fins 200A and the surface of the semiconductor layer 200S exposed between the adjacent fins 200A. Thereafter, the polysilicon film 233 is so formed as to fill between the adjacent fins 200A and between the fin 200A and the element isolation region 213.

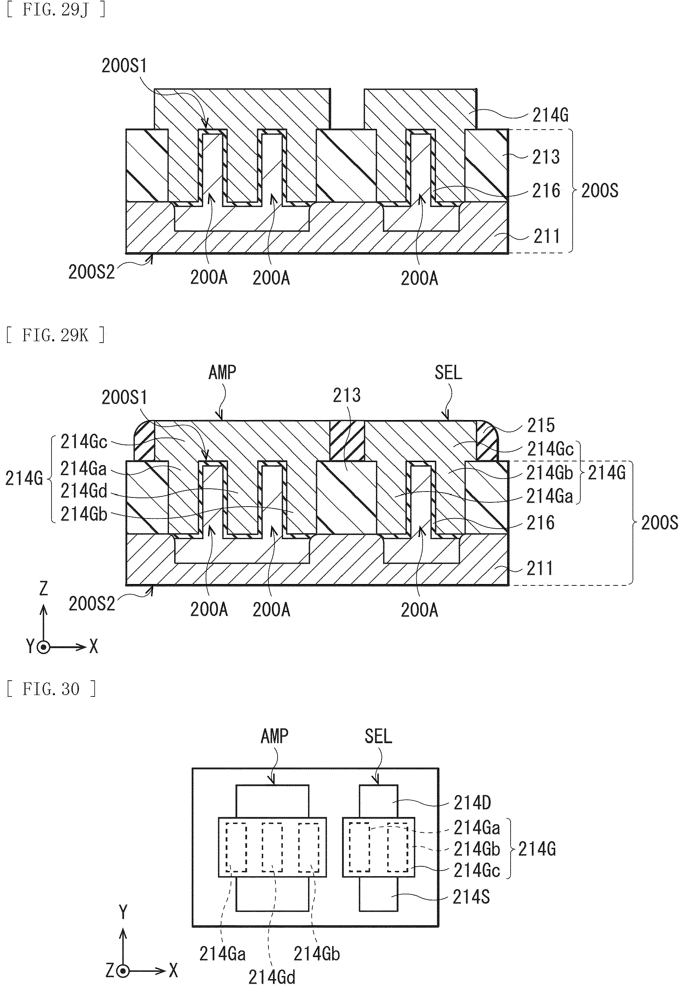

Thereafter, as illustrated in FIG. 29J, the polysilicon film 233 is processed. As a result, the gate electrode 214G of the pixel transistor (e.g., each of the amplification transistor AMP and the select transistor SEL) is formed. Thereafter, an n-type impurity (e.g., phosphorus (P)) is implanted in the active region 200X of the semiconductor layer 200S exposed from the gate electrode 214G to form the LDD region 214L, following which the sidewall 215 is formed on the side surface of the gate electrode 214G. Lastly, an n-type impurity (e.g., arsenic (As)) is implanted at a concentration higher than that for the LDD region 214L to form the source region 214S and the drain region 214D. Thus, the pixel transistor illustrated in FIG. 29A, etc. is completed.

FIG. 30 schematically illustrates a plan configuration of the amplification transistor AMP and the selection transistor SEL illustrated in FIG. 29K. In the pixel transistor manufactured by the manufacturing process of the present modification example, because the element isolation region 213 is formed first, the trenches H3 formed at the outer edge of the active region at which the cutout part X is formed remain as they are. Therefore, the respective widths of the vertical parts 214Ga and 214Gb of the gate electrode 214G are greater than the respective widths of the vertical parts 214Ga and 214Gb of the gate electrode 214G formed at the cutout part X in the pixel transistor manufactured by the manufacturing process described in the embodiment above. Specifically, in the embodiment described above, the width of each of the vertical parts 214Ga and 214Gb of the gate electrode 214G is, for example, smaller than that of the vertical part 214Gd embedded in the active region of the amplification transistor AMP; whereas, the width of each of the vertical parts 214Ga and 214Gb of the gate electrode 214G formed by the manufacturing process of the present modification example is substantially the same as that of the vertical part 214Gd embedded in the active region of the amplification transistor AMP. The area of the gate electrode 214G is increased accordingly.

As described above, although the area efficiency decreases as compared with the pixel transistor of the embodiment described above, it is possible to form the pixel transistor that achieves effects similar to those of the embodiment described above also by forming the plurality of fins 200A after forming the element isolation region 213.

### [3. Application Examples]

### [Application Example 1]

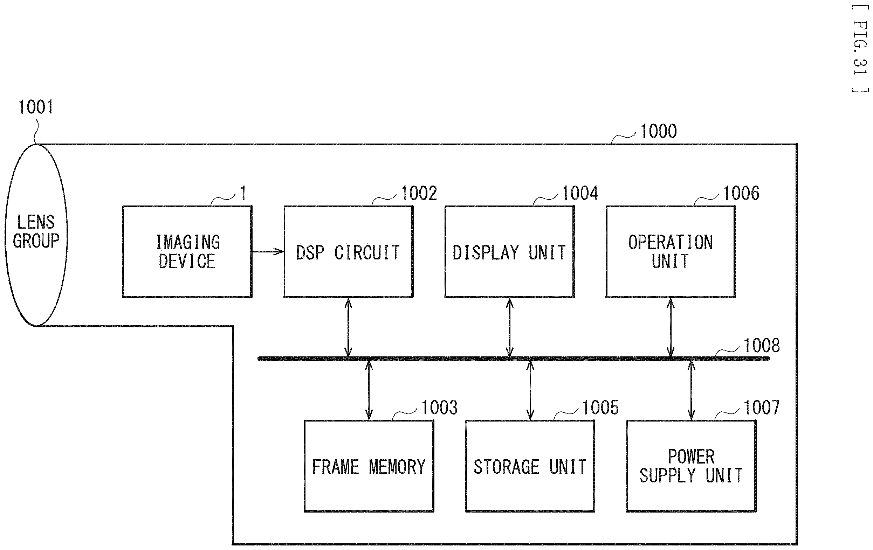

The imaging device 1 or the like described above is applicable to, for example, any type of electronic apparatus having an imaging function. Examples of such electronic apparatus include a camera system such as a digital still camera or a video camera, and a mobile phone having the imaging function. FIG. 31 illustrates a schematic configuration of an electronic apparatus 1000.

The electronic apparatus 1000 includes, for example, a lens group 1001, the imaging device 1, a DSP (Digital Signal Processor) circuit 1002, a frame memory 1003, a display unit 1004, a recording unit 1005, an operation unit 1006, and a power supply unit 1007 that are coupled to each other via a bus line 1008.

The lens group 1001 takes in entering light (image light) from a subject and forms an image on an imaging surface of the imaging device 1. The imaging device 1 converts an amount of the entering light used to form the image on the imaging surface by the lens group 1001 into an electric signal on a pixel unit basis, and supplies the electric signal to the DSP circuit 1002 as a pixel signal.

The DSP circuit 1002 is a signal processing circuit that processes a signal supplied from the imaging device 1. The DSP circuit 1002 outputs image data obtained by processing the signal from the imaging device 1. The frame memory 1003 temporarily holds the image data processed by the DSP circuit 1002 on a frame unit basis.

The display unit 1004 includes, for example, a panel-type display device such as a liquid crystal panel or an organic EL (Electro Luminescence) panel. The display unit 1004 records image data of a moving image or a still image captured by the imaging device 1 on a recording medium such as a semiconductor memory or a hard disk.

The operation unit 1006 outputs operation signals regarding various functions belonging to the electronic apparatus 1000, in accordance with an operation performed by a user. The power supply unit 1007 appropriately supplies various power supplies to be used as operation power supplies of the DSP circuit 1002, the frame memory 1003, the display unit 1004, the recording unit 1005, and the operation unit 1006, to these supply targets.

### [Application Example 2]

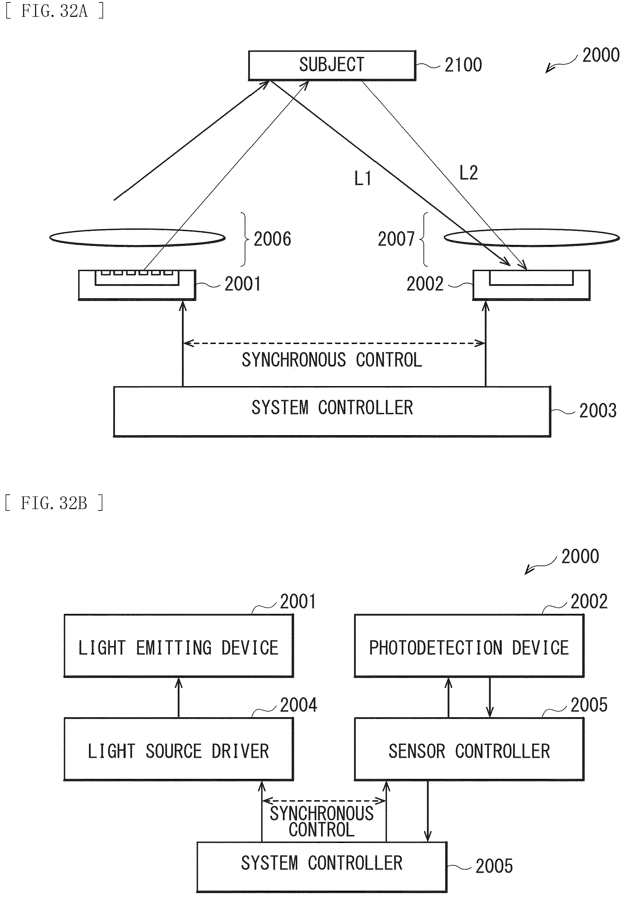

FIG. 32A schematically illustrates an example of an overall configuration of a photodetection system 2000 including the imaging device 1. FIG. 32B illustrates an example of a circuit configuration of the photodetection system 2000. The photodetection system 2000 includes a light emitting device 2001 as a light source unit that emits infrared light L2, and a photodetection device 2002 as a light receiving unit that includes a photoelectric conversion element. As the photodetection device 2002, it is possible to use the above-described imaging device 1. The photodetection system 2000 may further include a system controller 2003, a light source driver 2004, a sensor controller 2005, a light-source-side optical system 2006, and a camera-side optical system 2007.

The photodetection device 2002 is configured to detect light L1 and the light L2. The light L1 is light in which ambient light from an outside is reflected by a subject (an object to be measured) 2100 (FIG. 32A). The light L2 is light emitted by the light emitting device 2001 and thereafter reflected by the subject 2100. The light L1 is, for example, visible light, and the light L2 is, for example, infrared light. The light L1 is detectable by the photoelectric converter of the photodetection device 2002, and the light L2 is detectable by a photoelectric conversion region in the photodetection device 2002. It is possible to obtain image information of the subject 2100 from the light L1, and to obtain distance information between the subject 2100 and the photodetection system 2000 from the light L2. The photodetection system 2000 is mountable on, for example, an electronic apparatus such as a smartphone or a mobile body such as a vehicle. The light emitting device 2001 may include, for example, a semiconductor laser, a surface-emitting semiconductor laser, or a vertical cavity surface emitting laser (VCSEL). As a method of detecting, by the photodetection device 2002, the light L2 emitted from the light emitting device 2001, for example, an iTOF method may be employed; however, this is non-limiting. In the iTOF method, the photoelectric converter may measure a distance to the subject 2100 based on, for example, a time of flight (Time-of-Flight; TOF). For example, a structured light method or a stereo vision method may also be employed as the method of detecting, by the photodetection device 2002, the light L2 emitted from the light emitting device 2001. For example, in the structured light method, it is possible to measure a distance between the photodetection system 2000 and the subject 2100 by projecting light having a predetermined pattern onto the subject 2100, and analyzing a degree of distortion of the projected pattern. Further, in the stereo vision method, it is possible to measure the distance between the photodetection system 2000 and the subject by using two or more cameras and acquiring two or more images in which the subject 2100 is captured from two or more viewpoints different from each other. It is to be noted that the light emitting device 2001 and the photodetection device 2002 may be synchronously controlled by the system controller 2003.

### [4. Application Examples]

### [Example of Application to Endoscopic Surgery System]

The technique (the present technology) of the present disclosure is applicable to various products. For example, the technique of the present disclosure may be applied to an endoscopic surgery system.

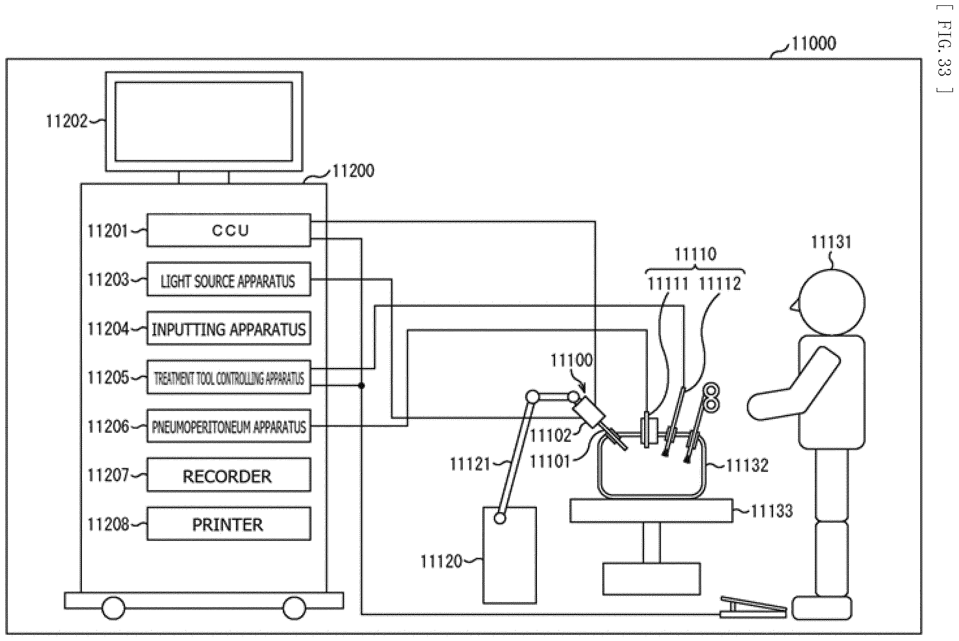

FIG. 33 is a view depicting an example of a schematic configuration of an endoscopic surgery system to which the technology according to an embodiment of the present disclosure (present technology) can be applied.

In FIG. 33, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

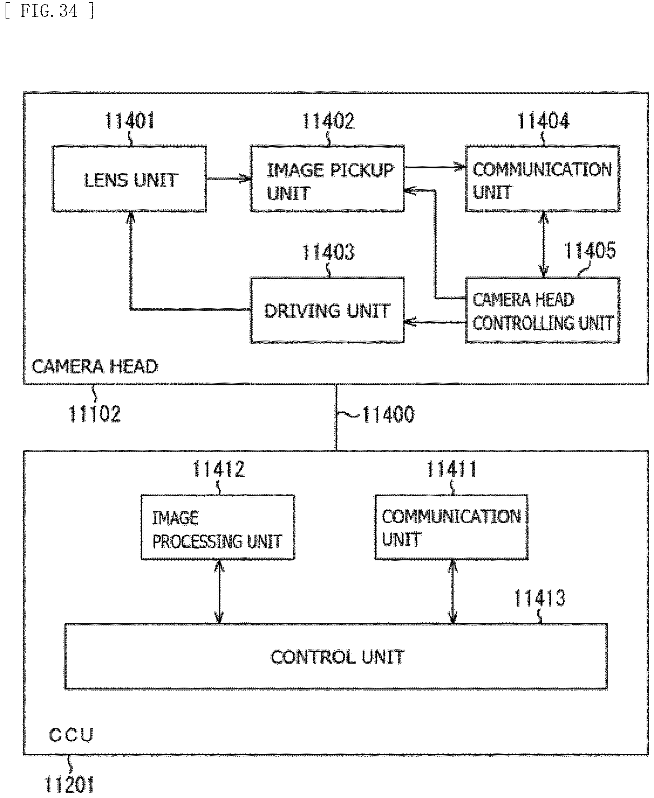

FIG. 34 is a block diagram depicting an example of a functional configuration of the camera head 11102 and the CCU 11201 depicted in FIG. 33.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technique according to the present disclosure is applicable has been described above. The technique according to the present disclosure is applicable to the image pickup unit 11402 in the configuration described above. Applying the technique according to the present disclosure to the image pickup unit 11402 improves detection accuracy.

It is to be noted that although the endoscopic surgery system has been described here as one example, the technique according to the present disclosure may be applied to, for example, any other system such as a microscopic surgery system.

### [Example of Application to Mobile Body]

The technique according to the present disclosure is applicable to various products. For example, the technique according to the present disclosure may be implemented as a device mounted on any type of mobile bodies including, without limitation, an automobile, an electric vehicle, a hybrid electric vehicle, a motorcycle, a bicycle, a personal mobility, an airplane, a drone, a vessel, a robot, a construction machine, an agricultural machine (a tractor), and the like.

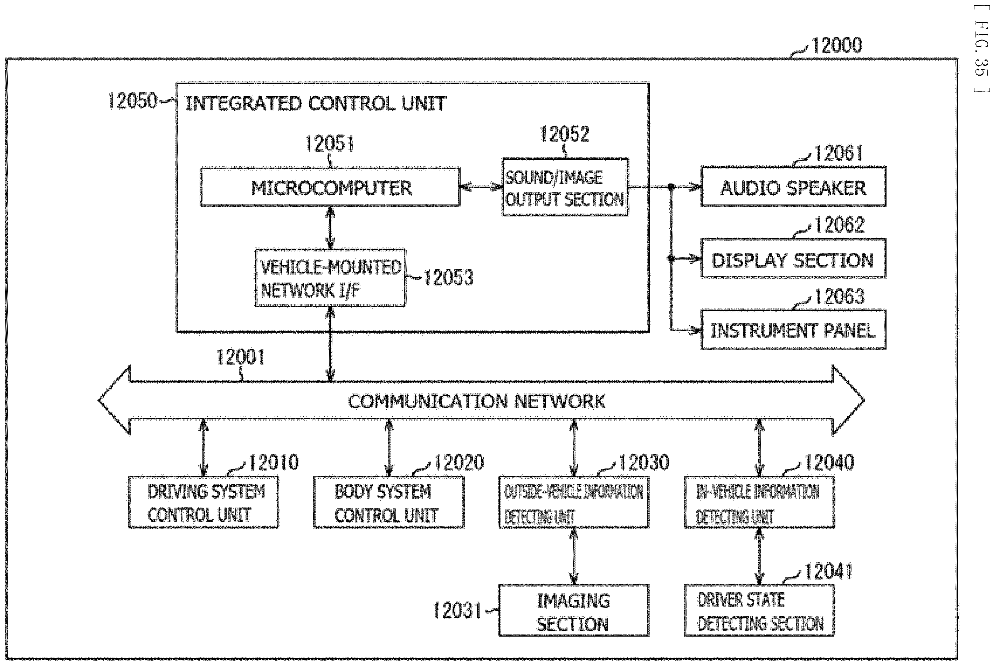

FIG. 35 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 35, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 35, an audio speaker 12061, a display section 12062, and an instrument panel 12063 are illustrated as the output device. The display section 12062 may, for example, include at least one of an on-board display and a head-up display.

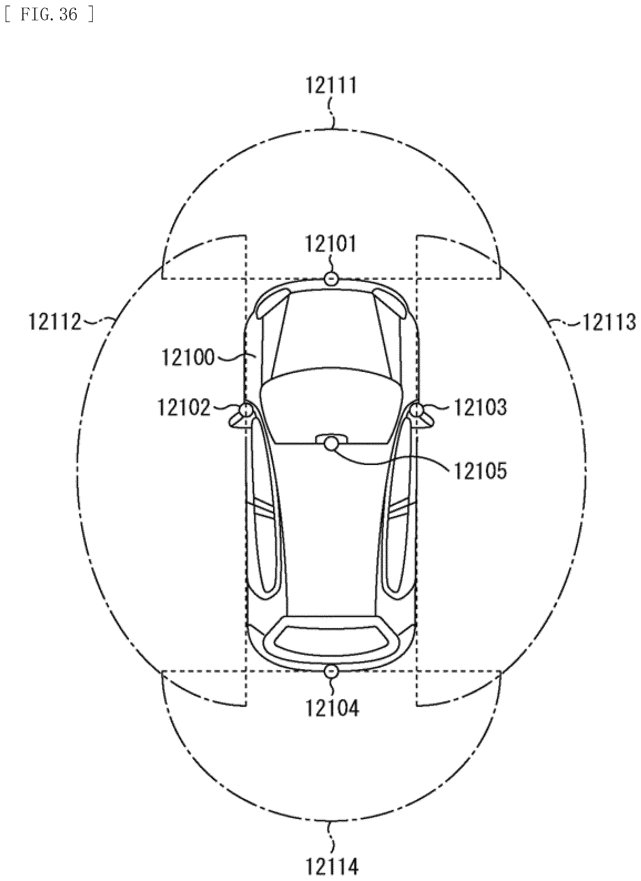

FIG. 36 is a diagram depicting an example of the installation position of the imaging section 12031.

In FIG. 36, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 36 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

Although the present disclosure has been described with reference to the embodiment described above, Modification examples 1 and 2 thereof, the application examples, and the practical application examples, the present disclosure is not limited to the embodiment, etc. described above, and may be modified in a variety of ways.

For example, the embodiment described above has referred to the example where the photoelectric converter (the photodiode PD) and the pixel circuit (the pixel circuit 210) are provided on the respective substrates (the first substrate 100 and the second substrate 200) different from each other; however, this is non-limiting. For example, the pixel circuit 210 may be formed, together with the transfer transistor TR, on the surface of the semiconductor layer 100S, included in the first substrate 100, on which the photodiode PD is formed. In this case also, it is possible to achieve similar effects by applying the present technology.

Further, the present technology is applicable to various semiconductor devices and electronic apparatuses other than the imaging device. Specifically, it is also applicable to an electronic apparatus including semiconductor elements including, without limitation, a photodetection element, a light receiving element, a photoelectric conversion element, an ionizing radiation energy conversion element, a semiconductor detector, an integrated circuit, and a memory. It is to be noted that in a case where the present technology is applied to the imaging device, as in the imaging device 1 of the embodiment described above, the configuration in which the photodiode PD and the pixel circuit 210 are provided on the respective substrates (the first substrate 100 and the second substrate 200) different from each other is less influenced by the p-well layer 112 included in the photodiode PD, and therefore makes it possible to achieve greater effects.

It is to be noted that the effects described herein are mere examples. Effects of the present disclosure are not limited to the effects described herein. The present disclosure may have effects other than the effects described herein.

It is to be noted that the present disclosure may also have any of the following configurations. According to any of the following configurations, in a first semiconductor layer in which a first electrode part and a second electrode part included in a gate electrode of a first active element are embedded, a non-doped first semiconductor region is formed between the first electrode part and the second electrode part. This allows the entire first semiconductor layer between the first electrode part and the second electrode part to be used as a channel region. Accordingly, it is possible to improve a device characteristic.
(1) An imaging device including:
   a photoelectric converter that generates electric charge corresponding to a light reception amount;
   a first active element that performs a predetermined operation on the electric charge generated by the photoelectric converter, and includes a gate electrode including a first electrode part, a second electrode part, and a third electrode part, the first electrode part and the second electrode part being provided side by side in a first direction, the third electrode part coupling the first electrode part and the second electrode part to each other; and
   a first semiconductor layer that includes a first surface and a second surface opposed to each other, has the first electrode part and the second electrode part of the gate electrode embedded in the first semiconductor layer on side of the first surface, and includes a first semiconductor region between the first electrode part and the second electrode part, the first semiconductor region being non-doped.
(2) The imaging device according to (1) described above, in which the photoelectric converter is formed to be embedded in the first semiconductor layer.
(3) The imaging device according to (1) or (2) described above, further including
   a second semiconductor layer stacked on side of the second surface of the first semiconductor layer with a wiring layer interposed between the first semiconductor layer and the second semiconductor layer, in which
   the photoelectric converter is formed to be embedded in the second semiconductor layer.
(4) The imaging device according to any one of (1) to (3) described above, further including
   an isolator outside the first semiconductor region, the isolator being embedded in the first surface of the first semiconductor layer and having an insulating property, in which
   the first semiconductor layer includes a second semiconductor region, the second semiconductor region being in contact with the isolator, extending to the second surface, and being doped with an impurity of a first conductivity type.
(5) The imaging device according to (4) described above, in which the second semiconductor region extends over an entire surface of the first semiconductor layer on side of the second surface.
(6) The imaging device according to any one of (1) to (5) described above, further including a second active element that is provided side by side with the first active element in the first direction, performs a predetermined operation on the electric charge generated by the photoelectric converter, and includes a gate electrode including a first electrode part, a second electrode part, and a third electrode part, the first electrode part and the second electrode part being provided side by side in the first direction, the third electrode part coupling the first electrode part and the second electrode part to each other.
(7) The imaging device according to (6) described above, in which
   the first semiconductor layer includes a protrusion part between a first standing part and a second standing part, the first standing part including the first semiconductor region provided between the first electrode part of the first active element and the second electrode part of the first active element, the second standing part including the first semiconductor region provided between the first electrode part of the second active element and the second electrode part of the second active element,
   the protrusion part is covered with an isolator that electrically isolates the first active element and the second active element from each other, and
   the first standing part, the second standing part, and the protrusion part have respective widths substantially same as each other in the first direction, and are disposed at equal intervals.
(8) The imaging device according to any one of (1) to (7) described above, in which
   the first active element includes
   a surface channel formed in vicinity of the first surface of the first semiconductor layer between the first electrode part and the second electrode part,
   a sidewall channel extending from the surface channel along each of a first side surface of the first electrode part and a first side surface of the second electrode part, the first side surface of the first electrode part and the first side surface of the second electrode part being opposed to each other, and
   a bottom channel and a transport channel, the bottom channel being formed on each of a bottom surface of the first electrode part and a bottom surface of the second electrode part and being continuous with the sidewall channel, the transport channel extending from vicinity of the surface channel along each of a second side surface of the first electrode part and a second side surface of the second electrode part and being continuous with the bottom channel, the second side surface of the first electrode part and the second side surface of the second electrode part being adjacent to the first side surface of the first electrode part and the first side surface of the second electrode part, respectively.
(9) The imaging device according to (8) described above, in which the sidewall channel has a width that narrows from the side of the first surface toward side of the second surface.
(10) The imaging device according to (8) or (9) described above, in which at least two the transport channels are formed for each of the bottom channel formed at the bottom surface of the first electrode part and the bottom channel formed at the bottom surface of the second electrode part.
(11) The imaging device according to any one of (1) to (10) described above, in which
   the first electrode part and the second electrode part each extend in a second direction substantially perpendicular to the first direction in a plan view,
   the first semiconductor layer includes the first semiconductor region and has an active region of the first active element in the plan view, the active region having a substantially rectangular shape that includes a pair of first sides corresponding to the second direction and a pair of second sides opposed to the first direction in the plan view, and
   the active region has a cutout part in at least one of the pair of the second sides, the cutout part being formed by embedding the first electrode part and/or the second electrode part.
(12) The imaging device according to any one of (1) to (11) described above, in which
   the first active element includes a fourth electrode part provided between the first electrode part and the second electrode part and coupled to the third electrode part, and
   the fourth electrode part is embedded in the first semiconductor region.
(13) The imaging device according to (12) described above, in which the first electrode part, the second electrode part, and the fourth electrode part have respective widths same as each other in the first direction.
(14) The imaging device according to (12) or (13) described above, in which the first electrode part and the second electrode part each have a width, in the first direction, that is smaller than a width of the fourth electrode part in the first direction.
(15) The imaging device according to any one of (1) to (14) described above, in which
   the first electrode part and the second electrode part each extend in a second direction substantially perpendicular to the first direction in a plan view,
   the third electrode part includes an overhang part that is formed on the first surface of the first semiconductor layer and overhangs outward from both ends of each of the first electrode part and the second electrode part in an extending direction, and
   an overhang width of a first overhang part from one end of the both ends of each of the first electrode part and the second electrode part and an overhang width of a second overhang part from another end of the both ends of corresponding one of the first electrode part and the second electrode part are different from each other, the first overhang part overhanging on side of the one end, the second overhang part overhanging on side of the other end.
(16) The imaging device according to (15) described above, in which
   the first semiconductor region extends in the second direction between the first electrode part and the second electrode part in the plan view, and
   the first semiconductor layer includes third semiconductor regions at both respective ends of the first semiconductor region in an extending direction of the first semiconductor region, the third semiconductor regions each being doped with an impurity of a second conductivity type.
(17) The imaging device according to (16) described above, in which
   the third semiconductor region on side of one end, of the third semiconductor regions formed at the both respective ends of the first semiconductor region in the extending direction of the first semiconductor region, is a source region of the first active element, and the third semiconductor region on side of another end, of the third semiconductor regions formed at the both respective ends of the first semiconductor region in the extending direction of the first semiconductor region, is a drain region of the first active element,
   the first overhang part overhangs on side of the source region,
   the second overhang part overhangs on side of the drain region, and
   the overhang width of the second overhang part is larger than the overhang width of the first overhang part.
(18) The imaging device according to any one of (1) to (17) described above, in which the first active element includes one or more transistors included in a pixel circuit that generates a pixel signal on the basis of the electric charge generated by the photoelectric converter.
(19) The imaging device including:
   a photoelectric converter that generates electric charge corresponding to a light reception amount;
   a first semiconductor layer that includes a first surface and a second surface opposed to each other; and
   a first active element that performs a predetermined operation on the electric charge generated by the photoelectric converter, and includes a gate electrode including a first electrode part, a second electrode part, and a third electrode part, the first electrode part and the second electrode part being provided side by side in a first direction, the third electrode part coupling the first electrode part and the second electrode part to each other, in which
   the first electrode part and the second electrode part are each embedded on side of the first surface of the first semiconductor layer, and each extend in a second direction substantially perpendicular to the first direction in a plan view,
   the third electrode part includes an overhang part that is formed on the first surface of the first semiconductor layer and overhangs outward from both ends of each of the first electrode part and the second electrode part in an extending direction, and
   an overhang width of a first overhang part from one end of the both ends of each of the first electrode part and the second electrode part and an overhang width of a second overhang part from another end of the both ends of corresponding one of the first electrode part and the second electrode part are different from each other, the first overhang part overhanging on side of the one end, the second overhang part overhanging on side of the other end.

The present application claims the benefit of US Patent Application No. 63/338,556 filed with the United States Patent and Trademark Office on July 12, 2022, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. An imaging device comprising:
a photoelectric converter that generates electric charge corresponding to a light reception amount;
a first active element that performs a predetermined operation on the electric charge generated by the photoelectric converter, and includes a gate electrode including a first electrode part, a second electrode part, and a third electrode part, the first electrode part and the second electrode part being provided side by side in a first direction, the third electrode part coupling the first electrode part and the second electrode part to each other; and
a first semiconductor layer that includes a first surface and a second surface opposed to each other, has the first electrode part and the second electrode part of the gate electrode embedded in the first semiconductor layer on side of the first surface, and includes a first semiconductor region between the first electrode part and the second electrode part, the first semiconductor region being non-doped.

2. The imaging device according to claim 1, wherein the photoelectric converter is formed to be embedded in the first semiconductor layer.

3. The imaging device according to claim 1, further comprising
a second semiconductor layer stacked on side of the second surface of the first semiconductor layer with a wiring layer interposed between the first semiconductor layer and the second semiconductor layer, wherein
the photoelectric converter is formed to be embedded in the second semiconductor layer.

4. The imaging device according to claim 1, further comprising
an isolator outside the first semiconductor region, the isolator being embedded in the first surface of the first semiconductor layer and having an insulating property, wherein
the first semiconductor layer includes a second semiconductor region, the second semiconductor region being in contact with the isolator, extending to the second surface, and being doped with an impurity of a first conductivity type.

5. The imaging device according to claim 4, wherein the second semiconductor region extends over an entire surface of the first semiconductor layer on side of the second surface.

6. The imaging device according to claim 1, further comprising a second active element that is provided side by side with the first active element in the first direction, performs a predetermined operation on the electric charge generated by the photoelectric converter, and includes a gate electrode including a first electrode part, a second electrode part, and a third electrode part, the first electrode part and the second electrode part being provided side by side in the first direction, the third electrode part coupling the first electrode part and the second electrode part to each other.

7. The imaging device according to claim 6, wherein
the first semiconductor layer includes a protrusion part between a first standing part and a second standing part, the first standing part including the first semiconductor region provided between the first electrode part of the first active element and the second electrode part of the first active element, the second standing part including the first semiconductor region provided between the first electrode part of the second active element and the second electrode part of the second active element,
the protrusion part is covered with an isolator that electrically isolates the first active element and the second active element from each other, and
the first standing part, the second standing part, and the protrusion part have respective widths substantially same as each other in the first direction, and are disposed at equal intervals.

8. The imaging device according to claim 1, wherein
the first active element includes
a surface channel formed in vicinity of the first surface of the first semiconductor layer between the first electrode part and the second electrode part,
a sidewall channel extending from the surface channel along each of a first side surface of the first electrode part and a first side surface of the second electrode part, the first side surface of the first electrode part and the first side surface of the second electrode part being opposed to each other, and
a bottom channel and a transport channel, the bottom channel being formed on each of a bottom surface of the first electrode part and a bottom surface of the second electrode part and being continuous with the sidewall channel, the transport channel extending from vicinity of the surface channel along each of a second side surface of the first electrode part and a second side surface of the second electrode part and being continuous with the bottom channel, the second side surface of the first electrode part and the second side surface of the second electrode part being adjacent to the first side surface of the first electrode part and the first side surface of the second electrode part, respectively.

9. The imaging device according to claim 8, wherein the sidewall channel has a width that narrows from the side of the first surface toward side of the second surface.

10. The imaging device according to claim 8, wherein at least two the transport channels are formed for each of the bottom channel formed at the bottom surface of the first electrode part and the bottom channel formed at the bottom surface of the second electrode part.

11. The imaging device according to claim 1, wherein
the first electrode part and the second electrode part each extend in a second direction substantially perpendicular to the first direction in a plan view,
the first semiconductor layer includes the first semiconductor region and has an active region of the first active element in the plan view, the active region having a substantially rectangular shape that includes a pair of first sides corresponding to the second direction and a pair of second sides opposed to the first direction in the plan view, and
the active region has a cutout part in at least one of the pair of the second sides, the cutout part being formed by embedding the first electrode part and/or the second electrode part.

12. The imaging device according to claim 1, wherein
the first active element includes a fourth electrode part provided between the first electrode part and the second electrode part and coupled to the third electrode part, and
the fourth electrode part is embedded in the first semiconductor region.

13. The imaging device according to claim 12, wherein the first electrode part, the second electrode part, and the fourth electrode part have respective widths same as each other in the first direction.

14. The imaging device according to claim 12, wherein the first electrode part and the second electrode part each have a width, in the first direction, that is smaller than a width of the fourth electrode part in the first direction.

15. The imaging device according to claim 1, wherein
the first electrode part and the second electrode part each extend in a second direction substantially perpendicular to the first direction in a plan view,
the third electrode part includes an overhang part that is formed on the first surface of the first semiconductor layer and overhangs outward from both ends of each of the first electrode part and the second electrode part in an extending direction, and
an overhang width of a first overhang part from one end of the both ends of each of the first electrode part and the second electrode part and an overhang width of a second overhang part from another end of the both ends of corresponding one of the first electrode part and the second electrode part are different from each other, the first overhang part overhanging on side of the one end, the second overhang part overhanging on side of the other end.

16. The imaging device according to claim 15, wherein
the first semiconductor region extends in the second direction between the first electrode part and the second electrode part in the plan view, and
the first semiconductor layer includes third semiconductor regions at both respective ends of the first semiconductor region in an extending direction of the first semiconductor region, the third semiconductor regions each being doped with an impurity of a second conductivity type.

17. The imaging device according to claim 16, wherein
the third semiconductor region on side of one end, of the third semiconductor regions formed at the both respective ends of the first semiconductor region in the extending direction of the first semiconductor region, is a source region of the first active element, and the third semiconductor region on side of another end, of the third semiconductor regions formed at the both respective ends of the first semiconductor region in the extending direction of the first semiconductor region, is a drain region of the first active element,
the first overhang part overhangs on side of the source region,
the second overhang part overhangs on side of the drain region, and
the overhang width of the second overhang part is larger than the overhang width of the first overhang part.

18. The imaging device according to claim 1, wherein the first active element comprises one or more transistors included in a pixel circuit that generates a pixel signal on a basis of the electric charge generated by the photoelectric converter.
